(19) Europäisches Patentamt
European Patent Office
Office européen des brevets

(11) **EP 3 200 192 B1**

(12) **EUROPEAN PATENT SPECIFICATION**

(45) Date of publication and mention
of the grant of the patent:
**06.01.2021 Bulletin 2021/01**

(51) Int Cl.:
***G11C 14/00*** *(2006.01)*

(21) Application number: **16000198.8**

(22) Date of filing: **27.01.2016**

(54) **NON-VOLATILE NON-SHADOW FLIP-FLOP**

NICHTFLÜCHTIGES SCHATTENLOSES FLIP-FLOP

BASCULE NON-SHADOW NON VOLATILE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**02.08.2017 Bulletin 2017/31**

(73) Proprietor: **Karlsruher Institut für Technologie**
**76131 Karlsruhe (DE)**

(72) Inventors:
• **Oboril, Fabian**
**76139 Karlsruhe (DE)**
• **Tahoori, Mehdi B.**
**76227 Karlsruhe (DE)**
• **Bishnoi, Rajendra**
**76676 Graben-Neudorf (DE)**

(74) Representative: **Müller-Boré & Partner**
**Patentanwälte PartG mbB**
**Friedenheimer Brücke 21**
**80639 München (DE)**

(56) References cited:
**US-A- 5 250 852     US-A1- 2003 141 911**
**US-A1- 2013 069 964     US-A1- 2015 213 869**

**Description**

Technical Field

The following description relates to a circuit enabling efficient power gating for short sleep periods.

Background

Flip-flop circuits (hereinafter also "flip-flops") are used as storage elements to drive the inputs and capture the outputs of digital integrated circuits used in microprocessors. The current technology for integrated circuits is based on complementary metal-oxide-semiconductor (CMOS), which are characterized by low static power consumption. However, there is an increasing demand for a greater power efficiency.

Indeed, the microprocessors found in electronic devices consume power also when no operation is being performed, e.g. during sleep mode. The reason is that static power is consumed via leakage currents and the smaller the size of the transistors, the more significant the static power consumption. Therefore, as CMOS technology (i.e. transistor sizes) keeps scaling down, it becomes important to reduce the leakage currents, especially for low-power applications such as battery-operated portable devices. The easiest way to reduce leakage dissipation during sleep mode is to turn off the power supply to the sleeping circuits and this technique is called power gating. Power gating introduces a shift from always-on towards normally-off/instant-on computing.

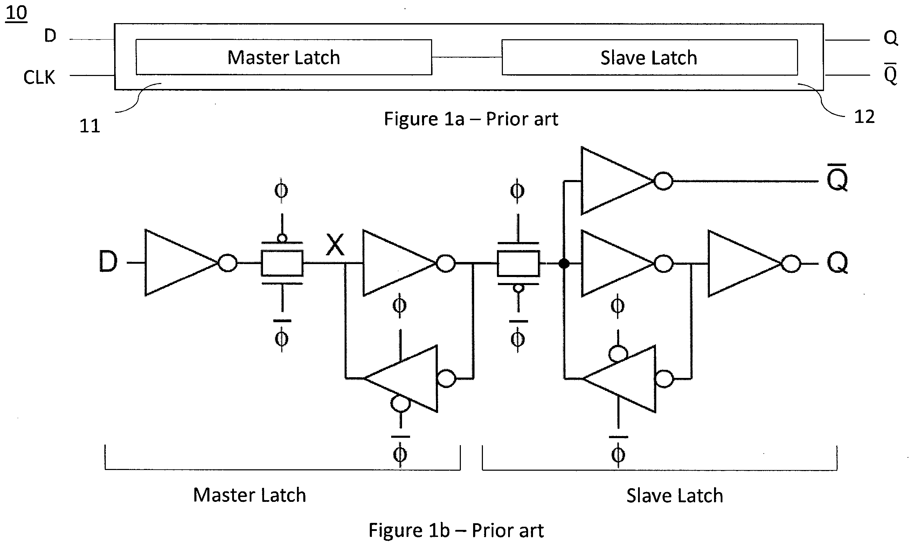

Unfortunately, conventional flip-flops provide a volatile memory, i.e. the information stored therein is lost when the power supply is interrupted. A conventional flip-flop 10 may be formed by combining a master latch 11 and a slave latch 12 in sequence, as shown in the schematic representation of **Figure 1a.** The flip-flop 10 captures the value of the input data D at a definite portion (e.g. rising edge) of the clock signal CLK and outputs the captured value at Q (and its opposite at Q). One exemplary implementation of a conventional, volatile flip-flop is given in **Figure 1b,** which is taken from "CMOS VLSI Design: A circuit and system perspective" by Neil H. E. Weste and David Harris, Third Edition, p.405.

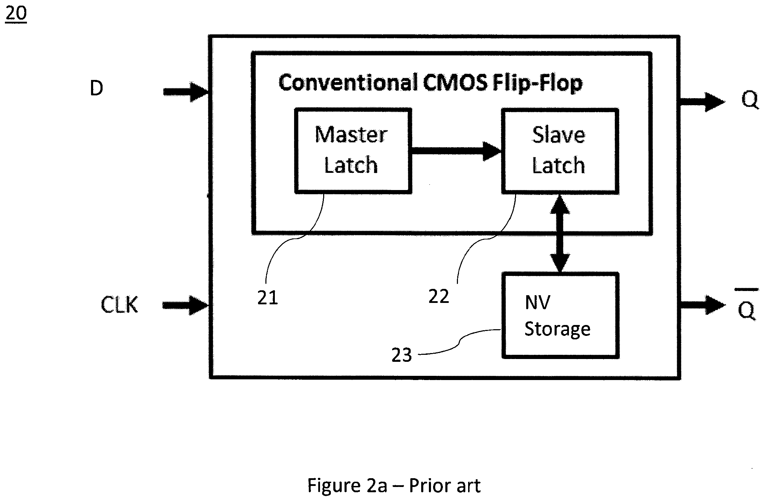

In order to perform power gating while retaining the state of the circuits, non-volatile solutions for flip-flops have been investigated. **Figure 2a** shows the schematic representation of a non-volatile flip-flop 20 according to the state of art. In comparison to the volatile flip-flop of Figure 1a, the slave latch 22 of the non-volatile flip-flop 20 is combined with a non-volatile storage 23 that is employed to backup data during sleep periods. In other words, during a sleep period, before power gating (i.e. interrupting the power supply), the data is copied into the non-volatile storage 23 of the slave latch 22. Then, during wake-up (i.e. after resuming the power supply) the data is restored into the conventional flip-flop. The combination of a conventional slave latch 22 with the non-volatile storage 23 is sometimes referred to as "backup" or "shadow" latch. Accordingly, the non-volatile flip-flop 20 may be denoted as non-volatile backup flip-flop or non-volatile shadow flip-flop.

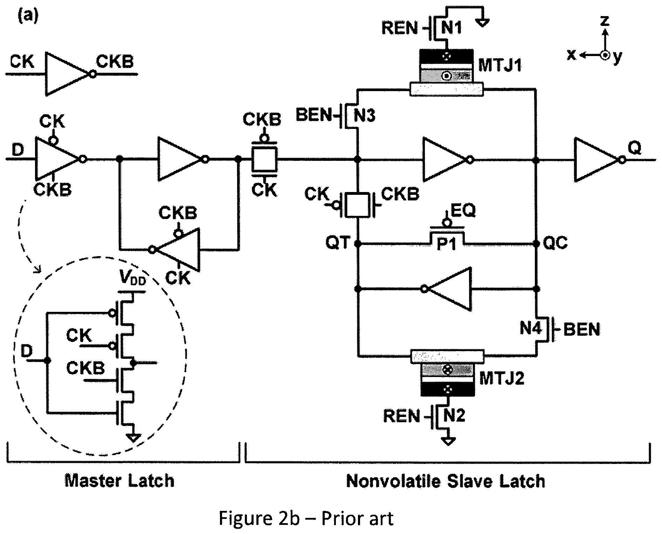

One exemplary implementation of such a non-volatile shadow flip-flop is shown in **Figure 2b,** which is taken from "SHE-NVFF: Spin Hall Effect-Based Nonvolatile Flip-Flop for Power Gating Architecture", by Kon-Woo Kwon, Sri Harsha Choday, Yusung Kim, Xuanyao Fong, Sang Phill Park and Kaushik Roy, IEEE ELECTRO DEVICE LETTERS, vol. 35, no. 4, April 2014. In Figure 2b, the non-volatile storage comprises two cells MTJ1 and MTJ2 each comprising a magnetic tunnel junction.

Document US 2015/213869 A1 discloses a single-phase non-volatile flip-flop (NVFF), which includes a master stage formed from a dual giant spin Hall effect (GSHE)-magnetic tunnel junction (MTJ) structure, the dual GSHE-MTJ structure comprising a first GSHE-MTJ and a second GSHE-MTJ coupled between a first combined terminal and a second combined terminal, and a slave stage formed from a first inverter coupled to a second inverter. During a single clock cycle of a clock, a first data value is read out from the slave stage when a clock is in a high state and a second data value is written into the master stage, when the clock is in a low state. The first and second inverters are cross coupled in a latch configuration to hold the first data value as an output, when the clock is in the low state.

Other prior art relevant for what is discussed herein is:

- "Synchronous 8-bit Non-Volatile Full-Adder based on Spin Transfer Torque Magnetic Tunnel Junction" by Erya Deng, Yue Zhang, Wang Kang, Bernard Dieny, Jacques-Olivier Klein, Guillaume Prenat and Weisheng Zhao, IEEE TRANSACTIONS ON CIRCUITS AND SYSTEMS-I: REGULAR PAPERS, VOL. 62, NO. 7, JULY 2015;
- "Asynchronous Asymmetrical Write Termination (AAWT) for a Low Power STT-MRAM" by Rajendra Bishnoi, Mojtaba Ebrahimi, Fabian Oboril and Mehdi B. Tahoori, DATE 2014;
- "Impact of Process-Variations in STTRAM and Adaptive Boosting for Robustness", by Seyedhamidreza Motaman, Swaroop Ghosh and Nitin Rathi, DATE 2015;
- "High Speed, High Stability and Low Power Sensing Amplifier for MTJ/CMOS Hybrid Logic Circuits" by Weisheng Zhao, Claude Chappert, Virgile Javerliac, and Jean-Pierre Nozière, IEEE TRANSACTIONS ON MAGNETICS, VOL. 45, NO. 10, OCTOBER 2009;

- "Impact of Process-Variations in STTRAM and Adaptive Boosting for Robustness", by Seyedhamidreza Motaman, Swaroop Ghosh and Nitin Rathi, DATE 2015.

Switching between the backup and active components for such flip-flops requires a complex control mechanism that contributes to delay and power consumption. Hence, this type of flip-flops is only feasible for long sleep durations (i.e. of the order of tens of nanoseconds), and is ineffective for short sleep durations (i.e. less than ten nanoseconds).

Therefore, for effective normally-off computing and aggressive power saving, it is crucial to exploit non-volatility also during short sleep periods.

Summary

It is an object of the invention to provide a non-volatile flip-flop that is efficient in terms of power consumption and timing characteristics for short sleep durations.

The achievement of this object in accordance with the invention is set out in the independent claims. Further developments of the invention are the subject matter of the dependent claims.

According to one aspect, a memory circuit is provided. The memory circuit comprises:

a volatile memory;
a write circuit;
a first non-volatile memory and a second non-volatile memory;
a read circuit; and
at least one selector circuit;
wherein:

- the memory circuit is configured to receive alternatively one of a first level clock signal and a second level clock signal;
- the memory circuit is configured such that during each first level clock signal:

-- the write circuit is configured to write new data stored in the volatile memory as current data into the first non-volatile memory and the second non-volatile memory; and
-- the volatile memory is configured to transmit the new data as the current data to the at least one selector circuit;

- the memory circuit is configured such that during each second level clock signal:

-- the read circuit is configured to read the current data stored in the first non-volatile memory and in the second non-volatile memory and transmit the current data to the at least one selector circuit; and
-- the volatile memory is configured to store new data; and

- the at least one selector circuit is configured to output the current data transmitted either by the volatile memory or by the read circuit, depending on whether the memory circuit is receiving the first level clock signal or the second level clock signal.

The memory circuit according to the above aspect of the invention will, in the following, also be referred to, generically, as a flip-flop, or, more specifically, as a non-volatile non-shadow flip-flop. Indeed, the features of the memory circuit as listed above and explained in further detail below lend a non-volatile character to the whole memory circuit at each moment of operation. The data is normally stored in the non-volatile storage during active mode, meaning that the data is not just transferred to/from the non-volatile memories in the phase of the active mode immediately preceding/following the sleep mode. In other words, unlike in the prior art discussed above, the data is always stored in the non-volatile storage in active mode, also when no power gating takes place. Consequently, entering the sleep mode and exiting the sleep mode is faster, i.e. it can be completed at an earlier point in time, because no additional data transferring operations are required. The data does not have to be written into the non-volatile storage before the sleep mode can be entered, because the data is already stored in the non-volatile memories. Similarly, when exiting the sleep mode, the data does not have to be transferred back from a backup storage, as it happens in the prior art. The reason is that the non-volatile memories are an integral part of the functioning of the memory circuit in active mode as well, i.e. the non-volatile memories are not a backup storage.

The features of the memory circuit that give rise to the above advantageous effects will now be described in more detail in the following.

The volatile memory may comprise a circuit used to store information, such as a latch, wherein the volatile memory retains the stored information only as long as electric power is supplied to the circuit by means of an applied voltage. The volatile memory may receive at least two input signals: a data signal and the clock signal. In some examples, the volatile memory may receive only the data signal and the clock signal.

The clock signal is a digital signal that oscillates between a first level and a second level with a given frequency. In other words, a sequence of a first level-second level (also called clock cycle) is repeated, always identical, a fixed number of times in a time unit. One level may correspond to a high state near a value of the applied voltage (e.g. 1 V) and the other level may correspond to a low state near a reference value (e.g. 0 V). In some cases it may also be the other way around. Exemplarily, the high state may be denoted with a '1' and the low state may be denoted with a '0'. The clock signal may be generated by a clock generator circuit. A person skilled in the art has sufficient knowledge about how to generate a clock signal. Unless otherwise specified, a clock signal has a duty cycle of 50%, i.e. the first level and the second level have the same duration.

The memory circuit, and at least some of the components of the memory circuit, are configured to receive the clock signal. Since the clock signal is alternatively at the first level or at the second level, it may also be said that the memory circuit and its components are configured to receive alternatively one of a first level clock signal and a second level clock signal, although there is only one single clock signal being received. When a certain operation is performed during the first level clock signal, it means that the operation is performed while the memory circuit is receiving the first level clock signal, i.e. the clock signal when it is at the first level. The same holds for the second level clock signal.

The data signal may also be a digital signal that can take either a first value or a second value (e.g. a '0' or a '1'). Therefore, the information carried by the data signal comprises only one bit and nothing else. A bit is a unit of data that can have only one of the two values of a binary state, which are in the following also referred to as "complementary values". Usually these values are denoted with 0 and 1: 0 is the complementary value of 1 and 1 is the complementary value of 0. Therefore, a bit value can be either 0 or 1 and, respectively, the complementary bit value will be 1 or 0. The bit value alone already carries all the information, however in some examples both the bit value and the complementary bit value may be transmitted to output lines as input for an integrated circuit.

By "storing data" or "writing data" in the volatile memory and in the non-volatile memory is meant that the bit value (e.g. 0 or 1) of the information bit is stored. In some cases, both the bit value and the complementary bit value are stored/ written.

For example, the volatile memory may receive the information consisting of one bit having one of a bit value and a complementary bit value and store the information as data comprising both the bit value and the complementary bit value. The non-volatile memories may also store collectively both the bit value and the complementary bit value, in that the first non-volatile memory may store the bit value and the second non-volatile memory may store the complementary bit value, or vice versa.

The volatile memory may be configured so that the information received from the data signal is stored as data in the volatile memory only when the clock signal is in a given level, i.e. the first level or the second level. In the following, operations will be described with reference to an example in which the volatile memory receives information and stores data during the second level clock signal. Since the second level may equally be 0 or 1, it is apparent that the same principles of functioning apply for a case in which the volatile memory receives information and stores data during the first level clock signal.

When the information is received by the volatile memory via the data signal, the stored data may be denoted as "new data". Also, as long as the data is only stored in the volatile memory, i.e. it has not been transmitted to any other component of the memory circuit, the data is still denoted as "new data". As it will be explained later, the new data is transmitted from the volatile memory to the write circuit and the at least one selector circuit. Once the new data is transferred from the volatile memory, it is denoted as "current data". The nature of the data does not change, i.e. the bit value of the new data stored in the volatile memory is carried on in the current data. The relation between "new data" and "current data" will be further discussed below.

Exemplarily, the new data may be stored in the volatile memory by means of a static latch, e.g. a latch provided with a feedback mechanism.

The volatile memory may be connected to the write circuit. The write circuit may receive at least two input signals: the data signal and the clock signal. In some examples, the write circuit may receive only the data signal and the clock signal.

The write circuit may receive the data signal from the volatile memory and write the new data stored in the volatile memory as current data into the first non-volatile memory and the second non-volatile memory. Exemplarily, the write circuit may perform the write operation (also referred to as "store operation") by making an electrical current flow in and/or by applying a voltage to the non-volatile memories. The write circuit may be configured so that the write operation occurs only when the clock signal is in the level opposite to the level in which the new data is stored in the volatile memory, e.g. during the first level clock signal.

Exemplarily, the write circuit may be configured to write the new data stored in the volatile memory as the current data into the first non-volatile memory and the second non-volatile memory by writing the bit value of the new data into the first non-volatile memory and the complementary bit value of the new data into the second non-volatile memory.

The non-volatile memories may be connected to the write circuit. A non-volatile memory retains the stored information even in the absence of a power supply. Different technologies may provide a non-volatile memory suitable for the object of the invention. These technologies may include, but are not limited to, ferroelectric capacitors, phase-changing capacitor-like structures and magnet tunnel junctions. A non-volatile memory may comprise storage elements capable of storing a bit value (e.g. either a 0 or a 1). For example, the state of the non-volatile memory may be a binary state, such as a physical state of conductivity or non-conductivity. If the non-volatile memory is in a conducive state, it may represent and, thus, store a 1 and if the non-volatile memory is in a non-conducive state, it may represent and, thus, store a 0, or vice versa.

The write operation may be such that the write circuit writes simultaneously to the first and second non-volatile memories the bit value and the complementary bit value. In other words, with only one write operation (e.g. by making one electrical current flow in both non-volatile memories) the bit value may be written to one of the first and second non-volatile memories and the complementary bit value may be written to the other of the first and second non-volatile memories. For example, the first non-volatile memory may store the bit value (e.g. a '0') and the second non-volatile memory may store the complementary bit value (e.g. a '1'), or vice versa. Therefore, the first non-volatile memory and the second non-volatile memory may simultaneously store the bit value and the complementary bit value.

The read circuit may be connected to the first and second non-volatile memories. The read circuit may receive at least the clock signal. Exemplarily, the read circuit may perform the read operation by making an electrical current flow in the non-volatile memories. The read circuit may be configured so that the read operation occurs only in the clock signal level following the level in which the write operation occurs. For example, in line with the above example, the read circuit may read the current data only during the second level clock signal. As explained before, the non-volatile memories store both the bit value and the complementary bit value of the current data. Accordingly, the read circuit may be configured to read both values at the same time.

The at least one selector circuit may be connected to the volatile memory and to the read circuit. Simultaneously to the write operation, i.e., following the above example, during the first level of the clock signal, the volatile memory may transmit the new data as current data to the at least one selector circuit. Exemplarily, the at least one selector circuit may be a multiplexer.

In one example, the memory circuit comprises exactly one selector circuit, i.e. a single one. Accordingly, the volatile memory may transmit the new data as the current data to the single selector circuit by transmitting only the bit value or by transmitting only the complementary bit value.

In another example, the memory circuit comprises two selector circuits, namely a first selector circuit and a second selector circuit. Accordingly, the volatile memory may transmit the new data as the current data to the first selector circuit and the second selector circuit by transmitting the bit value to the first selector circuit and the complementary bit value to the second selector circuit.

According to this example the memory circuit comprises said first selector circuit that receives the bit value from the first non-volatile memory and said second selector circuit that receives the complementary bit value from the second non-volatile memory.

The bit values can be received through the read circuit as described in this application.

In other words, according to a preferred embodiment, the memory circuit comprises no further selector circuits than the first and the second selector circuit.

Once the data has been read, i.e., following the above example, during the second level clock signal, the read circuit may transmit the current data to the at least one selector circuit.

In one example, the read circuit may transmit the current data to the selector circuit by transmitting only the bit value or by transmitting only the complementary bit value. If the memory circuit comprises two selector circuits, the read circuit is configured to transmit the current data stored in the first non-volatile memory and the second non-volatile memory to the first selector circuit and the second selector circuit by transmitting the bit value of the current data to the first selector circuit and the complementary bit value of the current data to the second selector circuit.

The at least one selector circuit may receive at least three input signals: a data signal from the volatile memory, a data signal from the read circuit and the clock signal. In some examples, the at least one selector circuit may receive only these three signals.

The clock signal may function as the selector input for the at least one selector circuit, i.e. according to the level of the clock signal, the data signal either from the volatile memory or from the read circuit is selected and forwarded to an output line. Therefore the at least one selector circuit provides the output signals of the circuit.

As explained before, the read circuit and the volatile memory, when transmitting the current data, can transmit, if there is only one selector circuit, only the bit value or only the complementary bit value. If there are two selector circuits, both the bit value and the complementary bit value may be transmitted by the read circuit and the volatile memory. In the latter case, the first selector circuit may be configured to output the bit value and the second selector circuit may be configured to output the complementary bit value (or vice versa).

It is apparent that the current data may only be read after having been stored. Therefore, an initial phase and a normal phase may be identified in the operations with reference to the clock signal. In particular, an initial phase may comprise a single second level clock signal (or part of it), during which information is received and stored as new data by the volatile memory. At this moment, the state of each non-volatile memory may be random, so that the read circuit may read random, non-relevant values. Hence, at this stage, the output may not yet be stable.

A normal phase, instead, may comprise a succession of first level clock signal-second level clock signal in which current data are first stored in the non-volatile memories, then read. In other words, the normal phase of the clock signal may be a sequence in which a pattern of a first level followed by a second level is repeated. During the first level clock signals of the normal phase, the new data stored in the volatile memory and being transmitted as current data to the one or more selector circuits coincides with the current data being written into the non-volatile memories. During the second level clock signals of the normal phase, the current data stored in and read from the non-volatile memories and transmitted to the one or more selector circuits may or may not coincide with the new data stored in the volatile memory. In other words, the new data cyclically becomes the current data and is replaced by more recent new data. The output data as outputted by the one or more selector circuits is always the current data and is, thus, consistent.

In summary, according to this aspect of the invention, the non-volatile storage, i.e. the first and second non-volatile memories, is not used merely as a backup storage for data when power gating is performed. Instead, the non-volatile storage forms an integral part of the circuit, in that operations are performed on the non-volatile storage in each clock cycle. In other words, the non-volatile storage stores the data also in active mode, i.e. when power supply is normally provided and a device is in normal operation, and not only in preparation for and in sleep mode, i.e. when power gating is applied, by cutting off the power supply to the idle components.

One advantageous effect is that powering down, i.e. entering the sleep mode, and powering up, i.e. exiting the sleep mode and returning into the active mode, require less time and energy in comparison with a non-volatile shadow circuit. Indeed, if the non-volatile storage is used only as a backup as is done in conventional prior art, powering down/up requires transferring the data to/from the non-volatile storage every single time, causing delay and energy consumption. In the memory circuit illustrated above, which is a non-volatile non-shadow circuit, the data is already stored in the non-volatile storage. Therefore, the powering down can start as soon as the data is written to the non-volatile storage and no transfer of data is needed when powering up. No additional energy is required for powering down/up with respect to the energy consumed in active mode, unlike what happens in a non-volatile shadow circuit. Advantageously, almost instantaneous power gating is enabled by the memory circuit described above, in that powering up/down is performed more quickly. Therefore, unlike in the conventional prior art, energy consumption reduction via power gating can efficiently be achieved even for short sleep periods.

It may be noted that the write operation to the non-volatile storage has to be finished within one level of the clock cycle, which is half of the clock cycle for a 50% duty cycle clock signal. Thus, the clock period (i.e. the inverse of the clock signal frequency) is longer than twice the write latency of the non-volatile storage. However, the write latency does not contribute to the critical path, i.e. the slowest logic path in the circuit that determines the clock frequency. In other words, the write latency of the non-volatile storage is "hidden", i.e. it does not increase the clock period, because the delay of the combinational logic in the circuit is usually dominant, as it will be explained in further detail later on.

It is the working principle of the circuit with respect to the clock signal that allows to "hide" this latency. Indeed, during e.g. the first level clock signal the writing is performed at the same time when the bit value and the complementary bit value are propagated from the volatile memory to the outputs via the at least one selector circuit. In other words, the volatile memory drives the outputs. Then, during the following second level clock signal, i.e. in the second half of the clock cycle, the volatile memory is configured to receive information and store new data, whereas the non-volatile storage drives the output via the read circuit and the at least one selector circuit. This switch in which component drives the output allows to advantageously include the non-volatile storage in the active mode operations.

In some cases, such as for high-performance processors with high clock frequencies and short combinational paths, the write latency may become critical. In these cases, the clock signal duty cycle may be modified so that the duration of the clock level during which the write operation is performed is increased, while the duration of the other level is reduced. In other words, according to one example, the duration of the first level clock signal may be longer than the duration of the second level clock signal while maintaining a clock signal period constant. Additional circuitry may be included in the memory circuit in order to achieve this setting.

Conversely, in cases in which the write operation takes less than half of the clock cycle, the duration of the write operation level may be decreased. The write operation may take less than half of the clock cycle depending on the relation between writing speed and clock frequency. Since writing requires energy, reducing the duration of the write operation level may lead to a reduction of the amount of energy consumed during the write operation by eliminating superfluous time (and consequently energy) used for writing. Therefore, according to another example, the duration of the first level clock signal is shorter than the duration of the second level clock signal. Again, additional circuitry may be included in the memory circuit in order to achieve this setting.

The amount of energy consumed during write operations can be reduced by decreasing the number of write operations, in that redundant write operations may be avoided. Redundant write operations indicate write operations in which the data to be written coincides with the data previously written. In other words, a write operation to the non-volatile storage is redundant if the bit value to be written into the non-volatile storage and the bit value read from the non-volatile storage (by the read circuit) are the same. Of course, if the bit values coincide, the complementary bit values also coincide, therefore only one of the two values may be checked in order to determine whether a write operation is redundant.

According to one example, the circuit may further comprise a comparison circuit, which, during the first level clock signal, is configured to determine whether there is a match between the current data stored in the first and second non-volatile memories and the new data stored in the volatile memory.

With reference to what was explained previously, an initial first level clock signal may be defined, i.e. a first level clock signal in the normal phase that immediately follows the initial phase. This initial first level can only occur once, namely before any data is stored in the non-volatile memories. During the initial first level clock signal; the data stored in the first and second non-volatile memories is data that was stored in the non-volatile storage before the beginning of operations, i.e. before the start of the clock signal. In this case, the stored data value may correspond to a default, random state of the non-volatile memories.

During other first level clock signals of the normal phase, the current data stored in the first and second non-volatile memories is the data that has been written into the non-volatile storage during a first level prior to the first level at which the determination is taking place.

The write circuit is configured to write the new data stored in the volatile memory as current data into the first non-volatile memory and the second non-volatile memory only if there is not a match. In other words, the write circuit writes the new data into the non-volatile memories only if it is different from the current data stored in the non-volatile memory. Exemplarily, determining that there is no match means finding a difference between the bit value stored in the volatile memory and the bit value stored in the first non-volatile memory, e.g. one is 0 and the other one is 1 or vice versa.

For example, the comparison circuit may be implemented by means of logic gates (e.g. a XOR gate) that compare e.g. the bit value stored in the non-volatile storage as read by the read circuit with the bit value stored in the volatile memory. As mentioned, the determination may be made for only one of the bit value and the complementary bit value.

The result of the determination may be used to create a new clock signal based on the original clock signal and the new clock signal may be fed as input to the write circuit. Therefore, a new clock signal may be internally generated, e.g. by means of a logic gate such as an AND gate in the comparison circuit. The logic gate takes as inputs the comparison result signal and the original clock. In other words, an internal clock gating scheme may be employed, where the clock becomes active only if the input and output values of the non-volatile storage differ.

The new clock signal may also be fed to the read circuit, whereas the volatile memory and the at least one selector circuit may use the original clock signal in order to prevent any metastability and/or additional delays.

The advantageous effect of avoiding redundant write operations is a reduction of the power consumed in active mode. It should be noted that in the non-volatile non-shadow design the write power is dominating, so that decreasing the number of write operations indeed improves the power efficiency.

According to a preferred embodiment, the memory circuit further comprises a delaying element, which is configured such that, when powering up the memory circuit, the read circuit is powered up first.

One aspect of the present invention relates to a memory device comprising one or more memory circuits as described above.

In a preferred embodiment, the memory device comprises plural memory circuits.

In a preferred embodiment, the memory device is usable as the main memory or the working memory of a computing device, such as a personal computer, a laptop computer, mobile phone, a tablet computer, or any such device.

In a preferred embodiment, the memory device is usable as the random access memory of a computing device, such as a personal computer, a laptop computer, mobile phone, a tablet computer, or any such device.

One aspect of the present invention relates to a microprocessor comprising one or more memory circuits as described above. In a preferred embodiment, the microprocessor comprises plural memory circuits as on-chip memory.

One aspect of the present invention relates to a microcontroller comprising one or more memory circuits as described above. In a preferred embodiment, the microprocessor comprises plural memory circuits as on-chip memory.

One aspect of the present invention relates to a computing device comprising one or more memory devices as described above.

One aspect of the present invention relates to a method for storing information in a memory circuit, the method comprising:

receiving, by the memory circuit, alternatively one of a first level clock signal and a second level clock signal;
during each first level clock signal:

- writing, by a write circuit of the memory circuit, new data stored in a volatile memory of the memory circuit as current data into a first non-volatile memory and a second non-volatile memory of the memory circuit; and
- transmitting, by the volatile memory, the new data as the current data to at least one selector circuit of the memory circuit;

during each second level clock signal:

- reading, by a read circuit of the memory circuit, the current data stored in the first non-volatile memory and in the second non-volatile memory and transmit the current data to the at least one selector circuit; and
- storing, by the volatile memory, new data; and

outputting, by the at least one selector circuit, the current data transmitted either by the volatile memory or by the read circuit, depending on whether the memory circuit is receiving the first level clock signal or the second level clock signal.

Brief Description of the Drawings

Details of exemplary embodiments are set forth below with reference to the exemplary drawings. Other features will be apparent from the description, the drawings, and from the claims. It should be understood, however, that even though embodiments are separately described, single features of different embodiments may be combined to further embodiments.

Figure 1a shows a schematic representation of a volatile flip-flop according to the prior art.

Figure 1b shows an example of a volatile flip-flop according to the prior art.

Figure 2a shows a schematic representation of a non-volatile shadow flip-flop according to the prior art.

Figure 2b shows an example of a non-volatile shadow flip-flop according to the prior art.

Figures 3a, 3b and 3c show examples of a write circuit according to the prior art.

Figures 4a to 4e show examples of a sense amplifier circuit according to the prior art.

Figure 5a shows a schematic representation of a non-volatile non-shadow flip-flop.

Figure 5b shows the operations of a non-volatile non-shadow flip-flop with respect to a clock signal.

Figures 6a, 6b and 6c show a block diagram of a non-volatile non-shadow flip-flop.

Figures 7a, 7b and 7c show an example of a non-volatile non-shadow flip-flop.

Figure 8 shows a spin-orbit-torque-based magnetic tunnel junction cell.

Figure 9 shows an example of a non-volatile latch.

Figure 10 shows waveforms for different signals in a non-volatile non-shadow flip-flop.

Figure 11 shows waveforms for different signals in a non-volatile non-shadow flip-flop with a duty-cycle-modified clock signal.

Figure 12 shows a comparison circuit for a write avoidance scheme.

Figure 13 shows power gating durations for a non-volatile shadow flip-flop and a non-volatile non-shadow flip-flop.

Detailed Description

In the following, a detailed description of examples will be given with reference to the drawings. It should be understood that various modifications to the examples may be made. Unless explicitly indicated otherwise, elements of one example may be combined and used in other examples to form new examples.

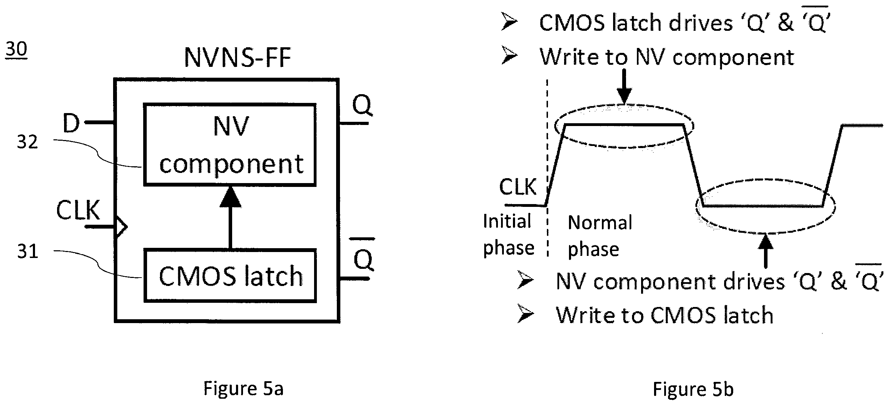

**Figure 5a** shows a schematic representation of a non-volatile non-shadow flip-flop (NVNS-FF) 30. It may be useful to draw a comparison between the NVNS-FF 30 and the non-volatile backup flip-flop (NVB-FF) 20 shown in Figure 2a. The NVB-FF 20, as already explained above, essentially consists of a conventional CMOS flip-flop 21 and 22 that is the only component fully operative during active mode and a non-volatile storage 23 that is only used as a backup for sleep mode.

In contrast to the NVB-FF 20, the NVNS-FF 30 fully integrates the non-volatile component 32 in the operations of the flip-flop during active mode. The NVNS-FF 30 has two input pins for a data signal D and a clock signal CLK and two output pins for output signals Q and $\overline{Q}$. The value of D is copied to Q, whereas the opposite of the value of D, i.e. $\overline{D}$, is copied to $\overline{Q}$. In the following, D will be used to denote both the signal and the bit value of the information carried by the signal. $\overline{D}$ is the complementary bit value.

The data is always stored in the non-volatile component 32, unlike in the NVB-FF 20, where the data is stored in the non-volatile storage 23 only for sleep mode. The NVNS-FF 30 also comprises a CMOS latch 31, which receives the data signal D and is a volatile memory. The CMOS latch 31 serves two purposes: it provides constant values for D and $\overline{D}$ during the write operation to the non-volatile component 32 and transmits D and $\overline{D}$ to the outputs Q and $\overline{Q}$ while the values are being written into the non-volatile component 32. Indeed, while being written, the data is not yet available to be read from the non-volatile component 32 and provided to the outputs Q and $\overline{Q}$.

The functioning of the NVNS-FF 30 can be better understood by looking at its operations with respect to a clock signal CLK, as shown in **Figure 5b.** In the following, a positive-edge triggered flip-flop will be described. However, it is apparent that the same concepts apply to a negative-edge triggered flip-flop.

A clock signal CLK has a first level and a second level, wherein, for example, the first level is the positive level that corresponds to the high state, 1 (e.g. 1 V), and the second level is the negative level that corresponds to the low state, 0 (e.g. 0 V). During the positive level, D is written to the non-volatile component 32, while, in parallel, the CMOS latch 31 drives the outputs Q and $\overline{Q}$. Thus, the CMOS latch acts as a pseudo-master in this architecture. During the negative level, it is the non-volatile component 32 that generates the outputs Q and $\overline{Q}$, since the write operation has been completed. Thus, in the meanwhile, the CMOS.latch 31 can capture a new incoming bit value D. Hence, the non-volatile component 32 can be seen as a pseudo-slave.

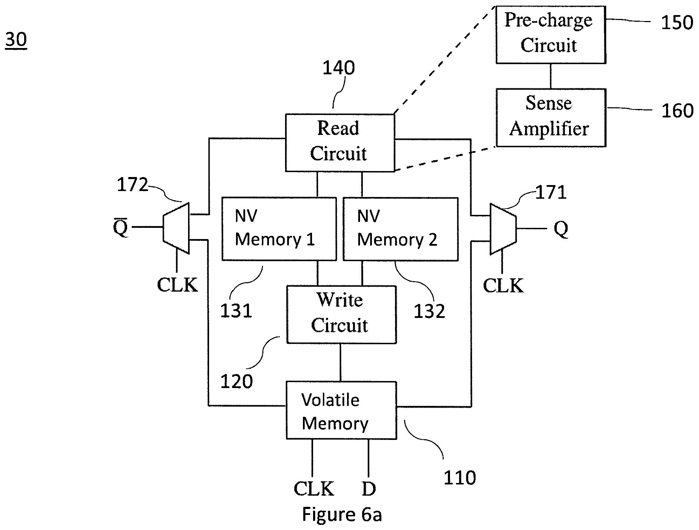

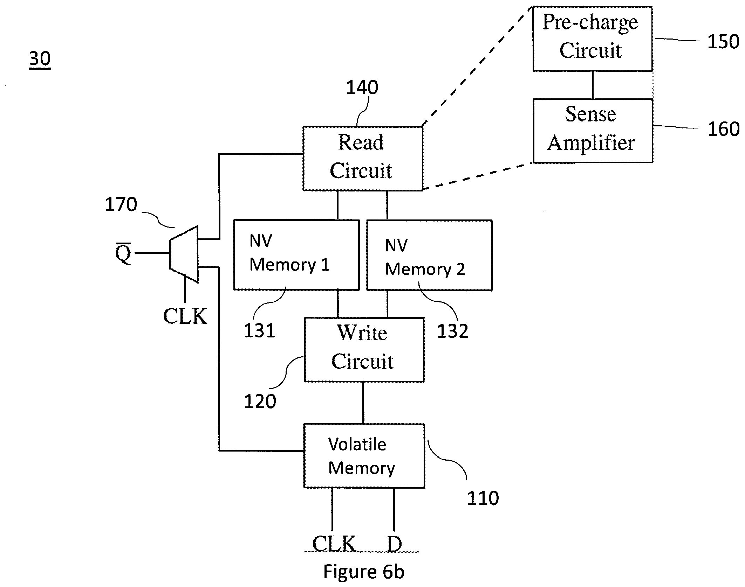

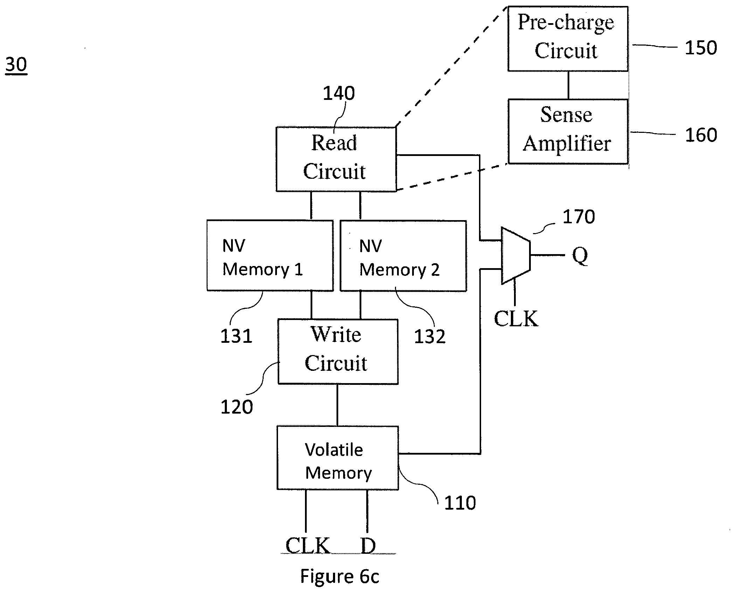

**Figures 6a, 6b and 6c** show a block diagram illustrating the circuit structure of the NVNS-FF 30. The NVNS-FF 30 may comprise a volatile memory 110, a write circuit 120, a first non-volatile memory 131, a second non-volatile memory 132, a read circuit 140, and at least one selector circuit. Figure 6a shows an example in which the memory circuit, that is, the NVNS-FF 30 comprises two selector circuits, namely a first selector circuit 171 and a second selector circuit 172. Figure 6b shows an example in which the memory circuit, that is, the NVNS-FF 30 comprises a single selector circuit 170 that outputs $\overline{Q}$. Figure 6c shows an example in which the memory circuit, that is, the NVNS-FF 30 comprises a single selector circuit 170 that outputs Q.

The operations of the NVNS-FF 30 will be described with reference to Figure 6a. However, it should be understood that the operations of the NVNS-FF 30 as described in the following can be equally performed with a single selector circuit 170 or with two selector circuits 171 and 172. The only difference is that only one value, i.e. either the bit value or the complementary bit value, can be transmitted to the single selector circuit 170 and, thus, the NVNS-FF 30 only has one output, Q or $\overline{Q}$.

The volatile memory 110 corresponds to the CMOS latch 31. The write circuit 120, the two non-volatile memories 131 and 132 and the read circuit 140 correspond to the non-volatile component 32.

The volatile memory 110 captures the information from the data signal and stores it as new data during the negative level of the clock signal CLK and provides the new data as current data to the selector circuits 171 and 172 during the positive level of the clock signal CLK. For example, one node of the CMOS latch, at which D can be found, may drive the first selector circuit 171 outputting Q and another node of the CMOS latch, at which $\overline{D}$ can be found, may drive the second selector circuit 172 outputting $\overline{Q}$.

Also during the positive level of the clock signal CLK, the write circuit 120 transfers the new data from the volatile memory 110 as current data to the first non-volatile memory 131 and to the second non-volatile memory 132. One non-volatile memory stores D while, simultaneously, the other non-volatile memory stores $\overline{D}$.

During the negative level of the clock signal CLK, the read circuit 140 reads the current data stored in the first non-volatile memory 131 and in the second non-volatile memory 132 and provides the current data to the selector circuits 171 and 172. Specifically, D is sent to the first selector circuit 171 outputting Q and $\overline{D}$ is sent to the second selector circuit 172 outputting $\overline{Q}$. To this purpose, the read circuit 140 may comprise two read nodes. At each read node, the value stored in only one non-volatile memory is read, i.e. either the bit value D or the complementary bit value $\overline{D}$.

As explained above, the description refers to a positive-edge-triggered flip-flop. For a negative-edge-triggered flip-flop, the read circuit 140 would read the current data during the positive level of the clock signal CLK.

The read circuit 140 may comprise a pre-charge circuit 150 and a sense amplifier circuit 160. The pre-charge circuit 150 may keep the two read nodes of the circuit at equal potential prior to the read operation, as will be explained in further detail below. The sense amplifier circuit 160 may amplify the read power signal.

The selector circuits 171 and 172 select the input lines coming from the volatile memory 110 during the positive level of the clock signal CLK and select the input lines coming from the read circuit 140 during the negative level of the clock signal CLK. In this way, the consistency and the continuous reading/availability of the outputs Q and $\underline{Q}$ are ensured.

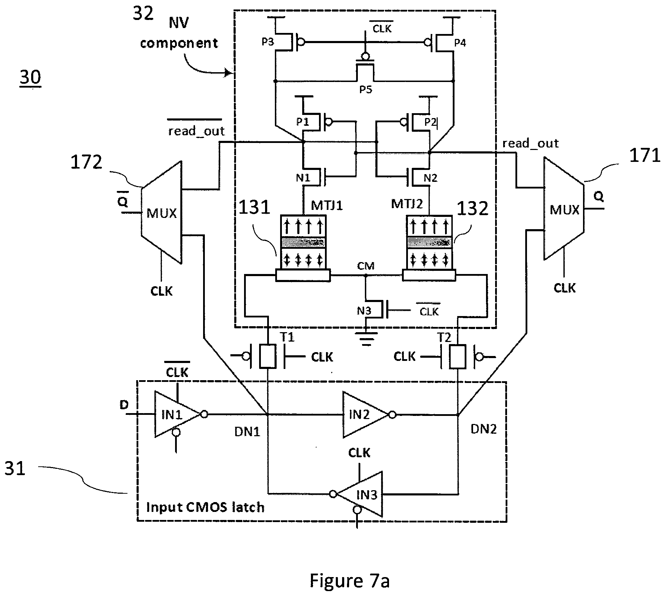

The implementation of the volatile memory 110, the write circuit 120 and the read circuit 140 may be achieved through different designs. Similarly, the technology for the non-volatile memories 131 and 132 may be selected among different options. **Figure 7a** shows an exemplary embodiment for the NVNS-FF 30, which should be construed merely as one possible implementation among a plurality of possible ones.

In the example of Figure 7a, the volatile memory 110 is the CMOS latch 31. The latch 31 comprises clocked (tristate) inverters IN1 and IN3 and inverter IN2. The input of the clocked inverter IN1 is connected to the D input of the NVNS-FF 30. The output of the clocked inverter IN1 is connected via node DN1 to the input of the inverter IN2 and to the output of the clocked inverter IN3. The output of the inverter IN2 is connected via node DN2 to the input of the clocked inverter IN3.

During the negative level of the clock signal CLK, D is driven through IN1 and applied to the node DN1, and then through IN2 and applied at DN2. Since both IN1 and IN2 are inverters, $\overline{D}$ is obtained at DN1 whereas D is obtained at DN2.

During the positive level of the clock signal CLK, the bit value D is latched using IN2 and IN3. In other words, IN2 and IN3 form a feedback loop that allows the latch 31 to be a memory and store data. At the same time, D and $\overline{D}$ are transferred from the nodes DN1 and DN2 to the output ports Q and $\overline{Q}$ via the selector circuits 171 and 172 and are written via the write circuit to the non-volatile storage. It should be noted that nodes DN1 and DN2 are disconnected from the data signal D for the positive level of the clock signal CLK, because IN1 does not let the signal through.

In the example of Figure 7a, the first non-volatile memory 171 and the second non-volatile memory 172 are magnetic tunnel junction (MTJ) cells MTJ1 and MTJ2, respectively. A MTJ cell is a component consisting of two ferromagnetic layers separated by a thin insulator (such as an oxide layer). According to quantum mechanics, electrons can tunnel from one ferromagnetic layer into the other. If the magnetizations of the two layers are in a parallel orientation (P magnetization state) it is more likely that electrons will tunnel through the insulator than if they are in the antiparallel orientation (AP magnetization state). MTJs are well known to the skilled person in this technical field. Consequently, a MTJ cell can be switched between two states of electrical resistance, one with low and one with very high resistance. The magnetization direction in the MTJs may be used for data storage, wherein '0' and '1' correspond to parallel and antiparallel magnetizations in the MTJ cell, respectively.

In order to control the magnetization of the ferromagnetic layers, different techniques may be employed, such as applying an external magnetic field or using a spin-polarized current to exploit the spin-transfer torque effect. In this exemplary implementation, the spin-orbit torque (SOT) effect is exploited, and the information bits can be written by passing a current through a MTJ.

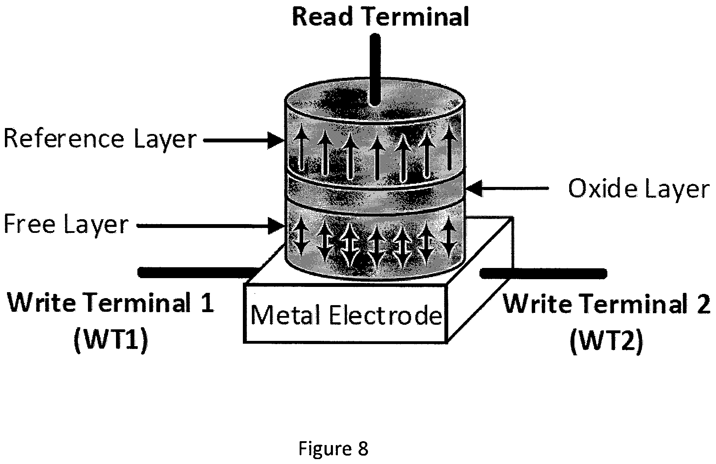

A SOT-based MTJ cell is shown in **Figure 8** as a three terminal storing device, out of which two are write terminals and one is a read terminal. As explained, the value is stored in the SOT-MTJ cell in the form of a resistance state influenced by the two ferromagnetic layers. Out of these two layers, one has always fixed magnetization (reference layer) and the other one (free layer) is varying based on the direction of the write current. The read is performed by passing a low current through the read terminal and one of the write terminals (WT2). To write a value, the magnetic orientation of the free layer is changed to either P or AP configuration, using a write current that flows between the two write terminals through the metal electrode. For instance, if the write current flows from 'WT1' to 'WT2', it leads to an 'AP' state switching and vice versa. SOT devices have a fast switching process. Furthermore, SOT also enhances the reliability due to its three terminal structure. The read and write current paths are isolated, meaning these can be optimized independently and the possibility of read disturb (unwanted switching during read operation) is almost zero. More importantly, since the write current does not pass through the oxide layer, it possesses higher endurance. SOT-based MTJ cells are well known to the skilled person in this technical field.

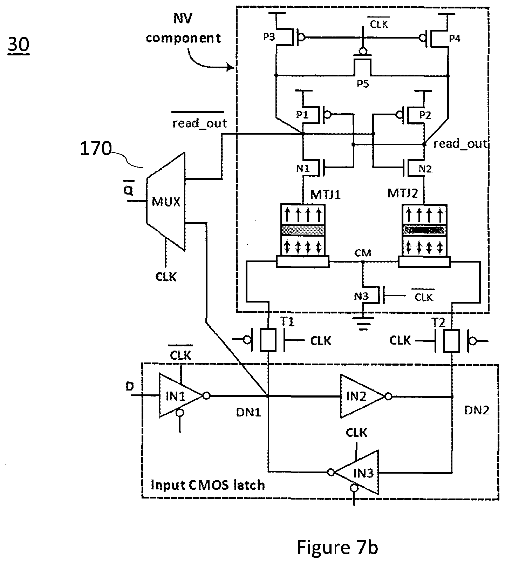

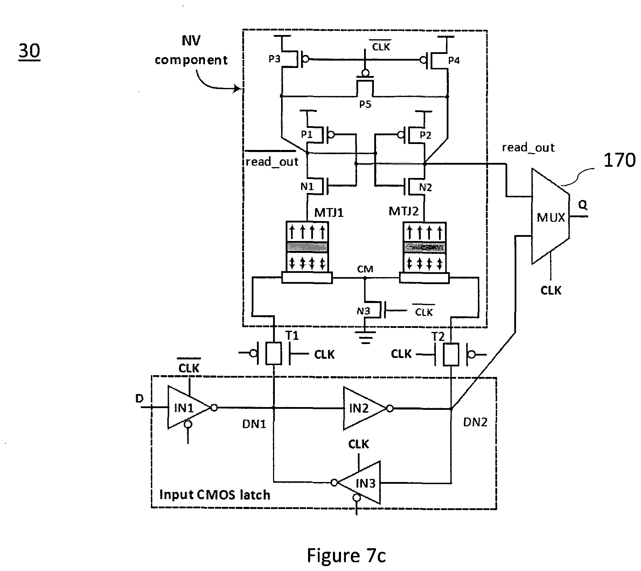

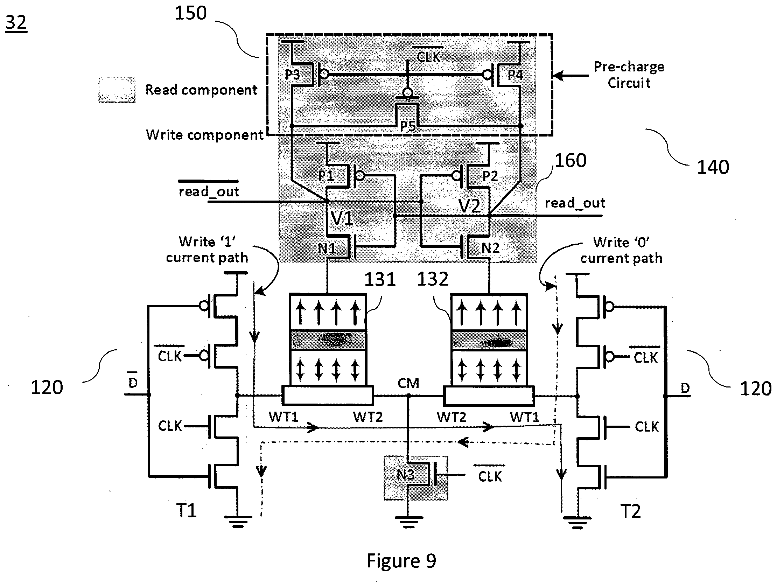

A non-volatile latch as shown in **Figure 9** may be used to store and read out the bit value and the complementary bit value for the first non-volatile memory 131 and the second non-volatile memory 132. The non-volatile latch of Figure 9 corresponds to the non-volatile component 32 of Figures 5a, 7a, 7b and 7c, which comprises the write circuit 120, the two non-volatile memories 131 and 132 and the read circuit 140. The circuits 120 and 130 comprise CMOS-based read and write component.

The write circuit 120 comprises two transmission gates T1 and T2. The input of the transmission gate T1 is $\overline{D}$, whereas the input of the transmission gate T2 is D. The output of the transmission gate T1 is connected to the W1 terminal of the MTJ1 cell and the output of the transmission gate T2 is connected to the W1 terminal of the MTJ2 cell. The two MTJ cells are arranged in such a way that a self-referencing structure can be employed, which is essential for fast and reliable read operations. Indeed, in a conventional structure with just one MTJ cell, the read circuit 140, or more specifically the sense amplifier circuit 160, requires a reference signal to determine whether the value stores in the MTJ cell is 1 or 0. Therefore a reference signal that is exactly in the middle of 1 and 0 is created by using multiple MTJ cells. However, this is too expensive for a flip-flop in terms of surface needed. In the self-referencing structure shown in Figure 9, two MTJs with opposite values are used. One of them can act as a reference in the sense that MTJ1 and MTJ2 are compared based on current levels. If the current through MTJ1 is lower than the current through MTJ2, then MTJ1 stores 1, otherwise 0. Therefore, the WT2 terminals of both cells are connected to node CM.

In this configuration, when current flows through the write terminals, it will flow from WT1 to WT2 for one cell, and in a reverse way for the other cell. By that means, at all times, one cell stores '1', whereas the other one stores '0' (or vice versa). Therefore, using the two MTJ cells in this configuration allows to write D and $\overline{D}$ with a single write operation, thereby making the writing faster. The current directions to write a value are illustrated in Figure 9. In this implementation, the write circuit 120 remains active only during the positive clock level.

The read circuit 140 comprises a sense amplifier circuit 160, a pre-charge circuit 150 and a tail transistor N3.

The sense amplifier circuit 160 includes two CMOS inverters V1 and V2 connected back to back. The N-type metal-oxide-semiconductor (NMOS) transistors N1 and N2 are connected to the cells MTJ1 and MTJ2, respectively. The output and its complementary value are obtained at the 'read out' and 'read out' nodes, respectively. If the sense amplifier 160 includes two back-to-back connected inverters V1 and V2 as shown in Figure 9, these inverters form a latch (i.e. memory element). Hence, this latch locks the value until a new read operation is performed.

The pre-charge circuit (or equalizer circuit) 150 comprises P-type metal-oxide-semiconductor (PMOS) transistors P3, P4 and P5. The pre-charge circuit 150 is connected to the 'read out' and 'read out' nodes and keeps the two nodes at equal potential before the read operation begins. The pre-charge may already be performed during the positive clock cycle (i.e. at the first level). In such a case, advantageously, a fast read during the subsequent negative clock cycle (i.e. at the second level) is possible. In other words, in order to achieve a fast read during a given negative clock cycle, already at the preceding positive clock cycle the pre-charge is carried out.

As mentioned, the write operation takes place only during the positive clock level, so no write current flows through the tail transistor 'N3' because it is off. However, this transistor is turned on at the negative level of CLK, when the read operation is performed. The stored values in the MTJ cells are read using the sense amplifier circuit. As explained, before the read is performed, the 'read out' and 'read out' nodes are at an equipotential because of the equalizer circuit 150. However, during the read execution, the equalizer circuit 150 is deactivated and at the same time, the tail transistor N3 is turned on. Thus, a read current flows through the MTJ cells. At this point, one of the output nodes instantly goes to a high steady state, while the other quickly reaches a low stable state, depending upon the resistance states of the two MTJ cells. The stabilization process is accelerated due to the two back-to-back connected inverters V1 and V2. Other ways to implement this function, specifically regarding the tail transistor, may be possible.

Coming back to Figure 7a, the inputs of the transmission gates T1 and T2 are connected to the nodes DN1 and DN2 of the CMOS latch 31, respectively. In another example, instead of transmission gates T1 and T2, clocked inverters may be used in the write circuit 120 in order to increase the write current. Indeed, the timing constraint for the write operation to the MTJ cells is basically half of the clock cycle, for a conventional clock signal having 50% duty cycle. In cases where the write operation is timing critical (i.e. close or even more than half of the clock cycle), the write current may be increased to reduce the write operation period. This is because the switching delay in the MTJ cells is a function of the applied write current, and the higher the write current the faster is the switching. However, higher current also accelerates wearout and increases energy consumption. Therefore, these have to be carefully traded off.

In summary, the NVNS-FF design comprises an input CMOS latch 31 and a non-volatile component 32 that operate as explained above with reference to Figures 5a to 9. As already explained above, the clock period has to be longer than twice the write latency of the employed MTJ cells. However, it is important to note that this latency is not additive to the critical path of the circuit. In fact, writing is performed at the same time when the values from the nodes DN1 and DN2 are propagated to the NVNS-FF outputs Q and $\overline{Q}$. Hence, the final clock period $T_{CP}$ follows Equation (1):

$$T_{CP} \geq max\{t_{CLK \rightarrow Q} + t_c + t_{setup}, 2t_{sot}\} \qquad (1)$$

where:

- $t_{CLK \rightarrow Q}$ is the CLK to Q delay, i.e. the time between when the input signal is captured on the clock positive edge and when the output has changed and is stable;
- $t_c$ is the delay of the combinational logic present in the circuit;
- $t_{setup}$ is the setup time for the circuit, i.e. the minimum amount of time before the clock positive edge by which the input must be stable; and
- $t_{sot}$ is the switching delay of the SOT-based MTJ cells (<300 ps).

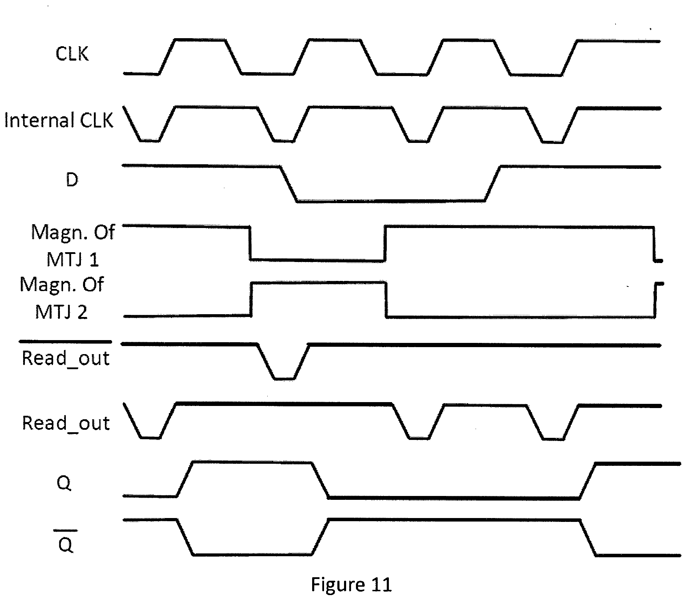

As a result, in low-power embedded processors, the combinational logic delay is dominating due to the usage of slow yet low-power gates. Thus, for these processors, which typically have a clock frequency of 1 GHz or less, the SOT write operation is not part of the critical path and consequently does not increase the clock period. High-frequency processors will be discussed with reference to Figure 11 below.

**Figures 7b and 7c** show others exemplary embodiments for the NVNS-FF 30, which are identical to the one shown in Figure 7a, except for the number of selector circuits. Figure 7b shows an embodiment in which the memory circuit comprises a single selector circuit 170 that outputs $\overline{Q}$, corresponding to the block diagram shown in Figure 6b. Figure 7b shows an embodiment in which the memory circuit comprises a single selector circuit 170 that outputs Q, corresponding to the block diagram shown in Figure 6c.

As already mentioned before, the specific implementation of the block elements of Figures 6a, 6b and 6c is not constrained to the embodiments of Figures 7a, 7b and 7c. On the contrary, many different possibilities exist and some are presented below.

For example, instead of SOT-based MTJ cells, spin-transfer torque (STT)-based MTJ cells, storage elements based on FeRAM or PCRAM technologies may be used.

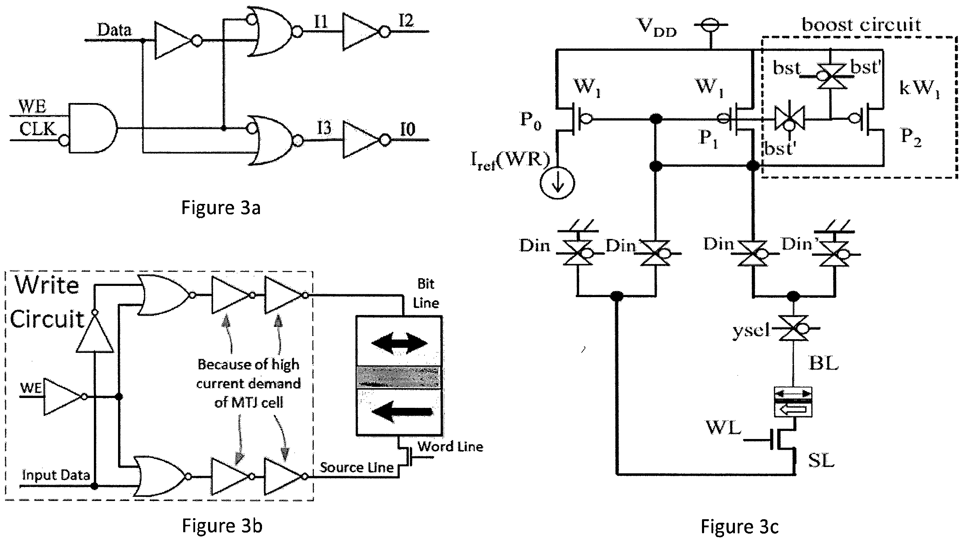

**Figures 3a, 3b and 3c** show some examples of alternatives for the write circuit 120. Figure 3a is taken from "Synchronous 8-bit Non-Volatile Full-Adder based on Spin Transfer Torque Magnetic Tunnel Junction" by Erya Deng, Yue Zhang, Wang Kang, Bernard Dieny, Jacques-Olivier Klein, Guillaume Prenat and Weisheng Zhao, IEEE TRANSACTIONS ON CIRCUITS AND SYSTEMS-I: REGULAR PAPERS, VOL. 62, NO. 7, JULY 2015, Figure 5. Figure 3b is taken from "Asynchronous Asymmetrical Write Termination (AAWT) for a Low Power STT-MRAM" by Rajendra Bishnoi, Mojtaba Ebrahimi, Fabian Oboril and Mehdi B. Tahoori, DATE 2014, Figure 2(a). Figure 3c is taken from "Impact of Process-Variations in STTRAM and Adaptive Boosting for Robustness", by Seyedhamidreza Motaman, Swaroop Ghosh and Nitin Rathi, DATE 2015, Figure 5(a).

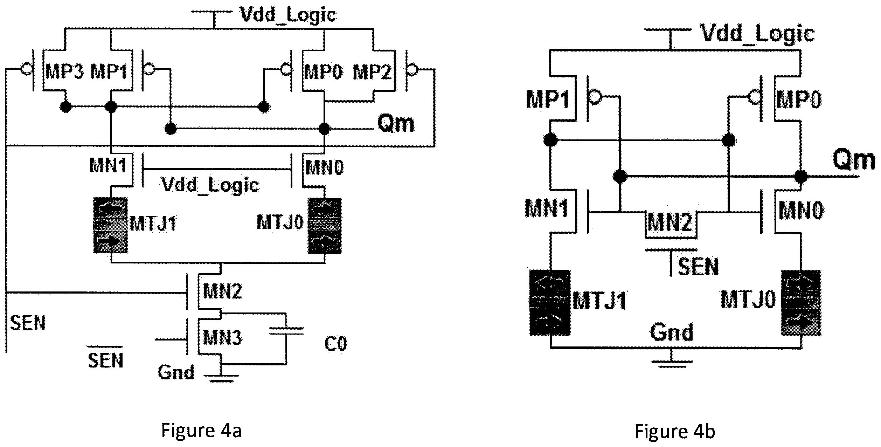

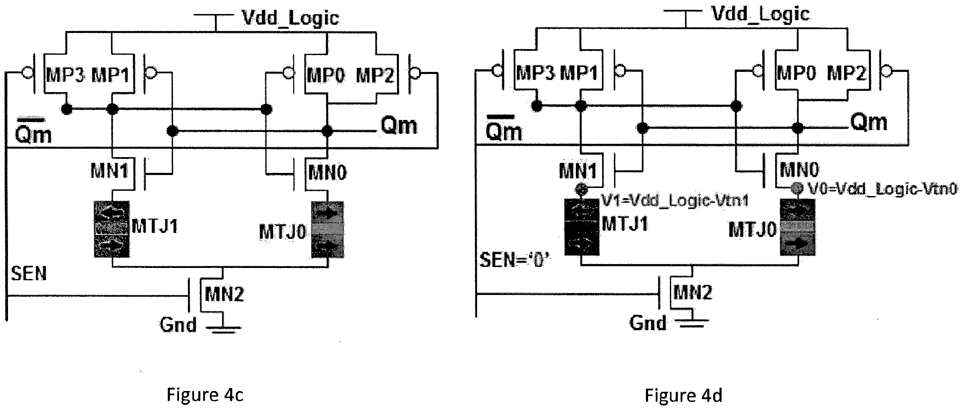

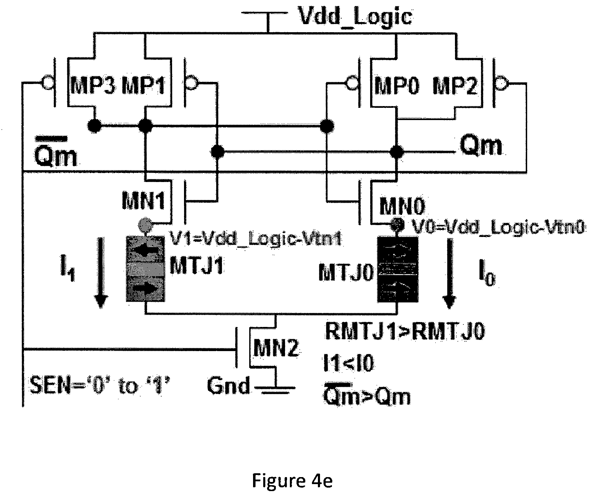

**Figures 4a to 4e** show examples of alternatives for the sense amplifier circuit. All these figures are taken from "High Speed, High Stability and Low Power Sensing Amplifier for MTJ/CMOS Hybrid Logic Circuits" by Weisheng Zhao, Claude Chappert, Virgile Javerliac, and Jean-Pierre Nozière, IEEE TRANSACTIONS ON MAGNETICS, VOL. 45, NO. 10, OCTOBER 2009, Figures: 2(a), 2(b), 3, 4 and 5.

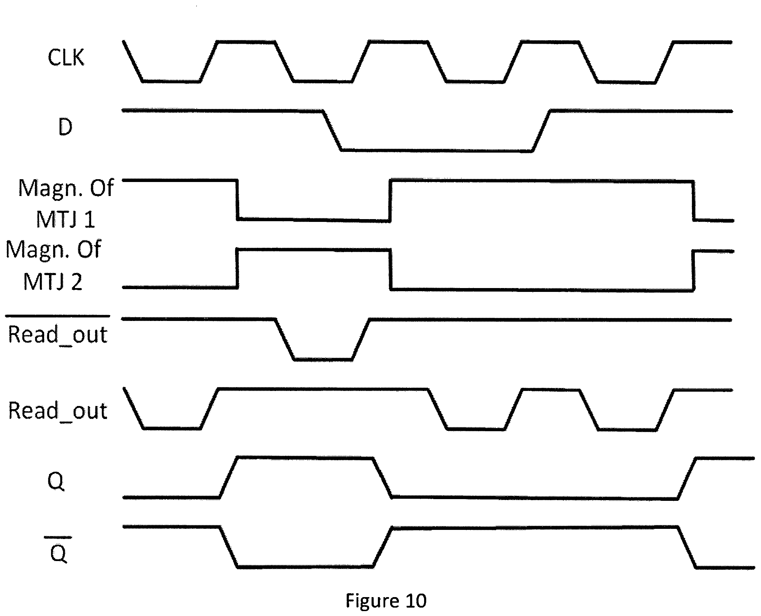

Independently of the particular implementation, the waveforms for the NVNS-FF design are shown in **Figure 10,** for an example in which a sequence of '101' is provided to the data input D. The magnetic orientations for both MTJ cells change at the positive edge of CLK, because that is when the write operation takes place, and the MTJ cells store the opposite magnetizations. The 'read out' and its complementary signals are generated at the negative edge of CLK, because the read operation takes place during the negative level. During the positive level of the clock signal, the sense amplifier is pre-charged and the 'read out' and 'read out' nodes are set on the same level, i.e. the high level. The final outputs Q and $\overline{Q}$ remain constant for the complete cycle and change based on the D value.

Referring back to equation (1), it has been showed how the SOT write operation is not part of the critical path for low-frequency processors. In high-performance processors that have a high clock frequency (more than 1 GHz), the positive level of the clock period (i.e. half of the clock cycle for 50% duty cycle) may not be enough to cover the write operation to the non-volatile storage component. In this case, the NVNS-FF 30 may have an additional internal clock CLKI that has the same clock period as CLK, but with a longer positive level, in order to reliably complete the write operation to the non-volatile memories 131 and 132. Therefore, the period with negative level will be relatively shorter. An example of the waveforms for the NVNS-FF design with a modified duty cycle is shown in **Figure 11.** The lower boundary for a high clock frequency may be around 1-2 GHz with the current technology, however this value may increase in the future.

Furthermore, advantageously the principle of adjusting the positive clock pulse width can not only be used for high-frequency designs to improve the critical path delay, but also to improve the energy efficiency of the NVNS-FF 30 for low-frequency applications. Here, the period of the positive clock level (for a write operation) can be reduced, to minimize the time during which current is flowing through the MTJ cells, which in turn reduces the amount of energy consumed during the write operation.

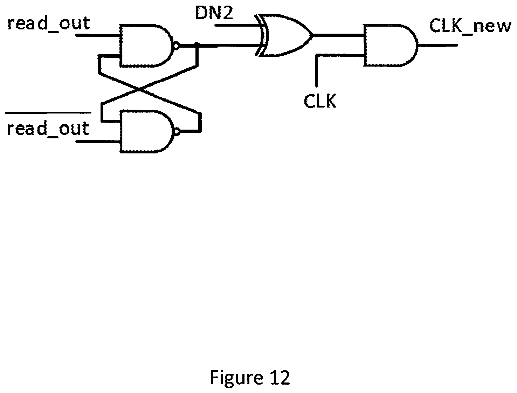

To reduce the power consumption in the NVNS-FF 30, redundant write operations can be avoided. In other words, if the value to be written is already stored in the MTJ cells, the write operation for the MTJ cells will not be performed. This write avoidance scheme may be implemented using a new clock signal that is generated internally via a comparison circuit as illustrated in **Figure 12.**

The comparison circuit compares the 'read out' value to the value of the DN2 node (i.e. D) using an XOR gate. A feedback structure using two NAND gates and both 'read out' and 'read out' values, as shown in the figure, may be employed to obtain a stable 'read out' value. The resulting XORed value is then gated with the standard clock signal CLK with the help of an AND gate, and the output signal is used as the new clock signal CLK_new for the design. In other words, an internal clock gating scheme is employed, where the clock becomes active only if the input and output values of the non-volatile component 32 differ. In fact, not only the write operations are avoided, but also read is not performed, as the equalizer circuit 150 remains disabled. All design components switch with the CLK_new signal except the input latch 31 inverters IN1 and IN3 and the selector circuits 171 and 172. The input latch 31 has to be operated with the original clock signal CLK to prevent any metastability conditions in the design, and the selector circuits 171 and 172 need to use the original clock signal CLK to evade any additional CLK to Q delay during the active mode when 'read out' and D are different.

By integrating the write avoidance scheme in the NVNS-FF design, write operations are performed in the MTJ cells only when it is necessary. In other words, current is flowing through the write terminals of the SOT-based MTJ cells only when a switch of the magnetization is required. Thus, this will also considerably improve the endurance of the non-volatile component 32 in the NVNS-FF. For instance, for an embedded low-power microprocessor with a clock frequency of 1 GHz, the average switching activity is very low, i.e. less than 2 %. Hence, in one year the average number of write operations is less than $6.3 \times 10^{14}$ and an average lifetime of 16 years may be expected. In addition, typically low-power devices are not permanently active. In fact, the active time is usually smaller than 1 %. Hence, even if a flip-flop has a switching activity of 100 %, the lifetime would be at least 30 years, and on average the lifetime is more than 100 years.

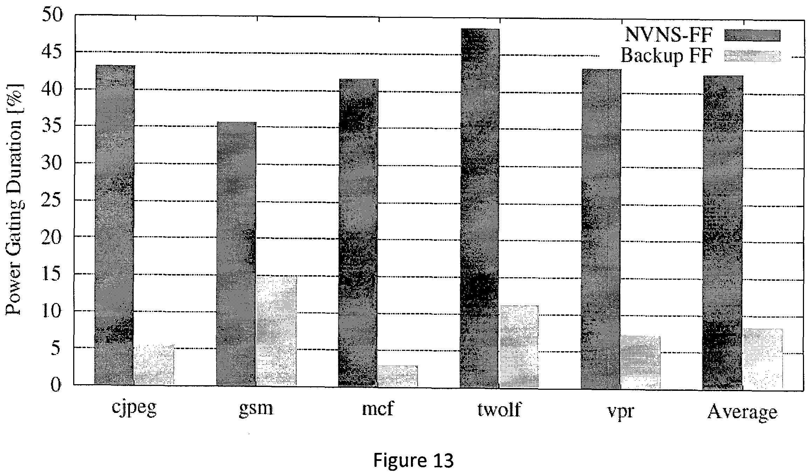

To summarize, using the proposed NVNS-FF, a complete design block can be quickly turned off for power gating. Unlike shadow architectures, the data is already stored in a non-volatile storage. Therefore, time for powering down and waking up is reduced so that the power-down time can be considerably increased, leading to significant energy savings (see also Figure 13 described below). The power gating scheme itself may be implemented with PMOS header or NMOS footer switches. During wake-up, the read circuit 140 should be powered up before the other flip-flop components as well as the combinational logic. By doing so, the wake-up sequences are boosted, and a higher energy efficiency is achieved due to a faster stabilizing process, i.e. the outputs of the NVNS-FF become stable at an earlier stage. Indeed, when turning a block on again, all the capacitors in the circuit have to be charged. Therefore, the larger the circuitry, the longer it will take to obtain a stable output. In one example, the memory circuit, i.e. the NVNS-FF 30, may comprise a delaying element that delays the powering up of the combinational logic and the flip-flop components except for the read circuit 140. In other words, the read circuit 140, during wake-up, is powered first, so that not all the capacitors in the memory circuit need to be charged before a stable output can be obtained, but only the capacitors in the read circuit 140.

In the following, experimental results showing the efficiency of the proposed NVNS-FF design are presented. Specifically, a circuit-level analysis as well as a comparison with a volatile CMOS flip-flop and a SOT-based non-volatile shadow flip-flop are performed.

Circuit-level analysis

For the circuit development, the setup detailed in Table I was employed. The SOT-MTJ Verilog-A model presented in "Compact model of a three-terminal MRAM device based on spin orbit torque switching," by K. Jabeur, G. Prenat, G. Di Pendina, L. Buda-Prejbeanu, I. L. Prejbeanu, and B. Dieny, in ISCDG, 2013, pp. 1-4, was used. Verilog-A is a language used to describe the analog behavior of circuits.

Table I

| Parameters | Value |
|---|---|
| VDD (Supply Voltage), Operating Temperature, Process corner | 1.0 V, 27°C, Typical |
| CMOS Technology | TSMC 65 nm GP |
| Damping factor | 0.5 |
| Thermal stability factor | 104 |
| Bias magnetic field | 0.1 T |
| Saturation Magnetization | $1.1 \times 10^6$ A/m |
| Metal Electrode of SOT-MTJ | 100 nm x 50 nm x 2.5 nm |
| Critical current | 59 uA |
| AP/P resistance | 10 K$\Omega$ / 5 K$\Omega$ |

The thermal stability factor of Table I describes how good/long is the retention of data in the SOT-MTJ cells without any refresh/rewrite operation. It is a function of several magnetic parameters, the temperature and the volume of the MTJ cells.

The simulations and characterization steps were performed with Cadence Spectre and Liberate, respectively. To extract the timing characteristics of the NVNS-FF, a slew value of 100 ps and a load capacitance of 10 fF were used. The slew value is that transition time of a signal from high-level to low-level or vice versa. The load capacitance is the capacitance seen at each gate output. Using this setup, the NVNS-FF can achieve remarkable timing values, as shown in Table II.

Table II

| Parameters | Rise [ps] | Fall [ps] |
|---|---|---|
| CLK→Q delay | 92.2 | 66.9 |
| CLK→$\overline{Q}$ delay | 81.3 | 56.8 |
| Setup time | 38.3 | 38.3 |
| Hold time | 39.2 | 36.7 |

As already explained, with reference to equation (1), the CLK to Q delay (and similarly the CLK to $\overline{Q}$ delay) is the time between when the input signal is captured on the clock positive edge and when the output has changed and is stable. The setup time is the minimum amount of time before the clock positive edge by which the input must be stable and the hold time is the minimum amount of time after the clock positive edge in which the input must be stable.

The important CLK to Q delay is less than 100 ps, whereas a conventional CMOS flip-flop requires typically more than 100 ps. In addition, the CLK to $\overline{Q}$ is even smaller than the CLK to Q delay, as Q is obtained from the node DN2 that drives a higher load than that of its counter node DN1, since IN3 is a clocked inverter. Also, the setup time values are comparable to conventional CMOS flip-flops, whereas the hold time values are slightly worse. In this regard it is important to note that for low-power systems the presented timing values are typically independent of the read and write delay to the SOT-based MTJ cells, as these are usually not in the critical path, as explained before. This is due to the fact that the clock frequency for these systems is low (1 GHz or less) and the SOT-based MTJ access is fast (<300 ps). Thus, the NVNS-FF is capable of providing similar timing characteristics as a conventional CMOS flip-flop in the active mode despite the fact of being non-volatile, i.e. the latency of the MTJ cells can be effectively hidden.

Comparison with state of the art

A comparison is made with state-of-the-art flip-flops in terms of energy efficiency and area. In detail, a conventional CMOS flip-flop such as the one shown in Figure 1b and the non-volatile backup flip-flop proposed in "SHE-NVFF: Spin Hall Effect-Based Nonvolatile Flip-Flop for Power Gating Architecture", by Kon-Woo Kwon, Sri Harsha Choday, Yusung Kim, Xuanyao Fong, Sang Phill Park and Kaushik Roy, IEEE ELECTRO DEVICE LETTERS, vol. 35, no. 4, April 2014 and shown in Figure 2b are considered. The latter is a flip-flop that uses the SOT-based non-volatile component only as a backup element, i.e. during active mode it works like a conventional CMOS flip-flop. The results of this comparison are summarized in Table III, wherein the starred (*) values for the NVNS-FF refer to the design including the write avoidance scheme.

Table III

| Parameters | Conventional CMOS | NVB-FF | NVNS-FF |
|---|---|---|---|
| Energy in active mode (fJ) | 13 | 13 | 59 and 63* |
| Power-down energy (fJ) | - | 66 | 52 and 56* |
| Wake-up energy (fJ) | - | 34 | 5 and 9* |
| Power-down delay (ps) | - | 983 | 266 (worst case) |
| Wake-up delay (ps) | - | 305 | 103 |
| Transistor count | 26 | 29 | 34 and 64* |
| MTJ count | 0 | 2 | 2 |

The first important result is the energy consumed in active mode (including switching, short-circuit and leakage power) by each flip-flop. While the NVB-FF requires a similar amount of energy to the conventional CMOS flip-flop (as the components used during the active time are basically the same as in a CMOS flip-flop), the NVNS-FF consumes 4.8X more energy, when new data is captured by the flip-flop. However, the average switching activity of the flip-flop data inputs is much lower than 30% (see also Table IV below). This means that on average, in less than 30% of all clock cycles new data is captured by a flip-flop. Consequently, with the write avoidance scheme, the average energy consumption reduces considerably. This saving is further magnified for microprocessors running real applications, as shown in Table IV.

Table IV reports the energy consumption values in active mode for the conventional CMOS flip-flop and the NVNS-FF for various ISCAS-89 benchmark circuits (i.e. exemplary test circuits consisting of standard logic gates) and two complete microprocessors, namely the OpenSPARC T1 and the FabScalar as presented in "FabScalar: Automating Superscalar Core Design" by N. Choudhary, S. Wadhavkar, T. Shah, H. Mayukh, J. Gandhi, B. Dwiel, S. Navada, H. Najaf-abadi, and E. Rotenberg, Micro, pp. 48-59, 2012.

Table IV

| Benchmarks | #FF | Avg Switching (%) | Avg Energy (pJ) | | |
|---|---|---|---|---|---|
| | | | CMOS | NVNS-FF | Saving (%) |
| s1423 | 14 | 6.9 | 0.35 | 0.32 | 11 |
| s5378 | 179 | 12.8 | 0.96 | 1.43 | -49 |
| s15850 | 534 | 9.3 | 2.69 | 3.10 | -15 |
| s13207 | 638 | 26.4 | 4.20 | 10.53 | -151 |
| s35932 | 1728 | 8.3 | 8.55 | 8.96 | -5 |
| Fabscalar | 7563 | 1.2 | 32.58 | 5.67 | 83 |
| OpenSPARC T1 | 10627 | 0.9 | 45.5 | 5.97 | 87 |

For example in case of FabScalar executing SPEC2000 workloads, the average energy in the active mode consumed by all flip-flops in the design is just 5 pJ using the NVNS-FF, whereas it is 32 pJ in case of conventional CMOS flip-flops (or backup flip-flops that rely on standard CMOS architectures during active mode). Hence, the NVNS-FF results in a lower average energy consumption in active mode than the other designs, if the average input switching activity is less than 8%. In cases where the switching activity is significantly higher (e.g. S13207 in Table IV), a selective replacement scheme can be employed, i.e. only a subset of flip-flops may be implemented using the proposed NVNS-FF. For instance, flip-flops storing data that does not require non-volatility (e.g. content of a branch predictor or microarchitecture flip-flops not constituting program/system state), can be implemented with conventional CMOS flip-flops.

The write avoidance scheme is not feasible for standard CMOS flip-flop designs, as the main source of power consumption in active mode is short circuit power during clock transitions due to the usage of transmission gates, even if the data input remains constant. Nevertheless, the power consumption in these cases is lower than in situations in which the input changes (three times lower), which is taken into account in Table IV.

Another important result is the energy required for data backup to enable power gating as well as the energy required to recover the data after power gating. As the NVNS-FF always uses a non-volatile component to store the data, the power-down can be initiated as soon as the data is captured in the MTJs, i.e. after less than 300 ps. The required energy corresponds to the energy necessary to write into the two SOT-based MTJ cells (52 fJ), i.e. the energy that is consumed during the first half (positive level) of a clock cycle, as extensively discussed above. In contrast, the NVB-FF requires three times more time to store the value in the non-volatile component and also the consumed energy is more (66 fJ).

Similarly, the NVNS-FF is also superior in terms of wake-up energy and delay. In fact, during the wake-up time the energy consumed by the NVNS-FF is more than four times lower and basically corresponds to the energy consumed during the second half (negative level) of a clock cycle in active mode. This huge advantage of the NVNS-FF design is due to high static currents in the NVB-FF, whereas the sensing scheme in the NVNS-FF has no direct current paths once the value is read out of the MTJ cells. In addition, the proposed NVNS-FF has a smaller wake-up delay, as the data does not need to be transferred from a shadow component to the main flip-flop before resuming the normal operation. It is worth noting that the energy spent for backup and wake-up by the backup flip-flop architecture is additional to the energy consumed in active mode, whereas there is no additional energy consumption for the NVNS-FF.

The last important point presented in Table III is the number of required transistors and MTJ cells, as this reflects the area required for the different flip-flop structures. This is the main advantage of the standard CMOS flip-flop as it requires only 26 transistors, compared to 29 transistors and 2 MTJs for the NVB-FF, and at least 34 transistors as well as 2 MTJs for the NVNS-FF. Indeed, if the scheme to avoid unnecessary write operations is employed, even 64 transistors have to be used in the NVNS-FF. Hence, area is traded-off to improve energy efficiency.

In summary, with the scheme to bypass redundant write accesses the NVNS-FF design has a very low energy consumption, which can be even lower than a conventional CMOS flip-flop in the active mode at the cost of an increased transistor count. In addition, it enables almost instantaneous power gating, which further helps to reduce the overall static power consumption, as further discussed in the following.

In order to illustrate the benefits of the NVNS-FF for power gating, several system-level applications we executed using GEM5, a cycle accurate performance simulator. Therefore, a low-power embedded processor core running at 1 GHz with an in-order instruction pipeline architecture as detailed in Table V was modeled.

Table V

| Processor | Single-core, 1 GHz, 5 Stages in-order |
| --- | --- |
| L1 Cache / L2 Cache | 32 KB / 512 KB Capacity |
| Execution units | ALU, CALU, FPU |
| Applications from real world scenarios | MiBench: CJPEG and GSM SPEC2000: MCF, TWOLF and VPR |

The execution units in Table V refer to the units that execute operations such as addition, multiplication, logic operations on integer and floating-point operands. The ALU is for integer and logic operations except for multiplication and division, which are executed by the CALU. The FPU is for floating-point operations.

The NVNS-FF design allows to power gate within one clock cycle, whereas the backup flip-flop implementation requires at least two clock cycles. However, short idle periods occur much more often than long idle periods, and as a result, a microprocessor using NVNS-FF can be power gated more effectively. As depicted in **Figure 13,** the total duration the microprocessor was power gated is on average 42% when the NVNS-FF is employed compared to only 8% for the scenario with backup flip-flops. Hence, a reduction of the overall leakage power by five times, on average, can be achieved. Figure 13 also shows the power gating duration for some benchmark applications, namely:

- cjpeg, a representative algorithm for image compression based on jpeg format;
- gsm, a representative algorithm for voice encoding/decoding according to the Global Standard for Mobile (GSM) communication;
- mcf, an application for combinatorial optimization problem for single-depot vehicle scheduling in public mass transportation;
- twolf:, a Place and Route Simulator; and
- vpr: Field Programmable Gate Array Circuit Placement and Routing.

**Claims**

**1.** A memory circuit (30) comprising:

a volatile memory (110);
a write circuit (120);
a first non-volatile memory (131) and a second non-volatile memory (132);
a read circuit (140); and
at least one selector circuit;
wherein:

- the memory circuit (30) is configured to receive alternatively one of a first level clock signal and a second level clock signal;
- the memory circuit (30) is configured such that during each first level clock signal:

-- the write circuit (120) is configured to write new data stored in the volatile memory (110) as current data into the first non-volatile memory (131) and the second non-volatile memory (132); and
-- the volatile memory (110) is configured to transmit the new data as the current data to the at least one selector circuit;

- the memory circuit (30) is configured such that during each second level clock signal:

-- the read circuit (140) is configured to read the current data stored in the first non-volatile memory (131) and in the second non-volatile memory (132) and transmit the current data to the at least one selector circuit; and
-- the volatile memory (110) is configured to store new data; and

- the at least one selector circuit is configured to output the current data transmitted either by the volatile memory (110) or by the read circuit (140), depending on whether the memory circuit (30) is receiving the first level clock signal or the second level clock signal.

2. The memory circuit (30) according to claim 1 comprising a first selector circuit (171) and a second selector circuit (172).

3. The memory circuit (30) according to claim 2, wherein:

- the volatile memory (110) is configured to:

-- receive information consisting of one bit having one of a bit value (D) and a complementary bit value ($\overline{D}$);
-- store the information as new data by storing both the bit value (D) and the complementary bit value ($\overline{D}$); and
-- transmit the new data as the current data to the first selector circuit (171) and the second selector circuit (172) by transmitting the bit value (D) to the first selector circuit (171) and the complementary bit value ($\overline{D}$) to the second selector circuit (172);

- the write circuit (120) is configured to write the new data stored in the volatile memory (110) as the current data into the first non-volatile memory (131) and the second non-volatile memory (132) by writing the bit value (D) into the first non-volatile memory (131) and the complementary bit value ($\overline{D}$) into the second non-volatile memory (132); and
- the read circuit (140) is configured to transmit the current data stored in the first non-volatile memory (131) and the second non-volatile memory (132) to the first selector circuit (171) and the second selector circuit (172) by transmitting the bit value (D) to the first selector circuit (171) and the complementary bit value ($\overline{D}$) to the second selector circuit (172).

4. The memory circuit (30) according to claim 3, wherein the write circuit (140) is configured to simultaneously write the bit value (D) into the first non-volatile memory (131) and the complementary bit value ($\overline{D}$) into the second non-volatile memory (132).

5. The memory circuit (30) according to any one of the preceding claims, further comprising a comparison circuit, wherein, during the first level clock signal:

- the comparison circuit is configured to determine whether there is a match between the current data stored in the first and second non-volatile memories (131, 132) and the new data stored in the volatile memory (110); and
- the write circuit (120) is configured to write the new data stored in the volatile memory (110) as current data into the first non-volatile memory (131) and the second non-volatile memory (132) only if there is not a match.

6. The memory circuit (30) according to any one of the preceding claims, wherein the duration of the first level clock signal is longer than the duration of the second level clock signal.

7. The memory circuit (30) according to any one of claims 1 to 5, wherein the duration of the first level clock signal is shorter than the duration of the second level clock signal.

8. The memory circuit (30) according to any one of the preceding claims, wherein:

- the first non-volatile memory (131) and the second non-volatile memory (132) each comprise a magnet tunnel junction including two ferromagnetic layers;
- the write circuit (120) is configured to write the new data stored in the volatile memory (110) as the current data into the first non-volatile memory (131) and the second non-volatile memory (132) by changing the magnetization of one of the two ferromagnetic layers; and
- the read circuit (120) is configured to read the current data stored in the first non-volatile memory (131) and in the second non-volatile memory (132) by comparing a current level through the first non-volatile memory (131) with a current level through the second non-volatile memory (132).

9. The memory circuit (30) according to any one of the preceding claims further comprising a delaying element, which is configured such that, when powering up the memory circuit (30), the read circuit (140) is powered up first.

10. A microprocessor comprising one or more memory circuits (30) according to any one of the preceding claims 1 to 9.

11. A method for storing information in a memory circuit (30), the method comprising:

receiving, by the memory circuit (30), alternatively one of a first level clock signal and a second level clock signal;
during each first level clock signal:

- writing, by a write circuit (120) of the memory circuit (30), new data stored in a volatile memory (110) of the memory circuit (30) as current data into a first non-volatile memory (131) and a second non-volatile memory (132) of the memory circuit (30); and
- transmitting, by the volatile memory (110), the new data as the current data to at least one selector circuit of the memory circuit;

during each second level clock signal:

- reading, by a read circuit (140) of the memory circuit (30), the current data stored in the first non-volatile memory (131) and in the second non-volatile memory (132) and transmit the current data to the at least one selector circuit; and
- storing, by the volatile memory (110), new data; and

outputting, by the at least one selector circuit, the current data transmitted either by the volatile memory (110) or by the read circuit (140), depending on whether the memory circuit (30) is receiving the first level clock signal or the second level clock signal.

12. The method according to claim 11, wherein the memory circuit (30) comprises a first selector circuit (171) and a second selector circuit (172), the method further comprising:

receiving, by the volatile memory (110), information consisting of one bit having one of a bit value (D) and a complementary bit value ($\overline{D}$);
storing, by the volatile memory (110), the information as new data by storing both the bit value (D) and the complementary bit value ($\overline{D}$);
transmitting, by the volatile memory (110), the new data as the current data to the first selector circuit (171) and the second selector circuit (172) by transmitting the bit value (D) to the first selector circuit (171) and the complementary bit value ($\overline{D}$) to the second selector circuit (172);
writing, by the write circuit (120), the new data stored in the volatile memory (110) as the current data into the first non-volatile memory (131) and the second non-volatile memory (132) by writing the bit value (D) into the first non-volatile memory (131) and the complementary bit value ($\overline{D}$) into the second non-volatile memory (132); and
transmitting, by the read circuit (140), the current data stored in the first non-volatile memory (131) and the second non-volatile memory (132) to the first selector circuit (171) and the second selector circuit (172) by transmitting the bit value (D) to the first selector circuit (171) and the complementary bit value ($\overline{D}$) to the second selector circuit (172).

13. The method according to claim 12, wherein:
writing, by the write circuit (120), the new data stored in the volatile memory (110) as the current data comprises simultaneously writing the bit value (D) into the first non-volatile memory (131) and the complementary bit value ($\overline{D}$) into the second non-volatile memory (132).

14. The method according to any one of the preceding claims, further comprising, during the first level clock signal:

determining, by a comparison circuit, whether there is a match between the current data stored in the first and second non-volatile memories (131, 132) and the new data stored in the volatile memory (110); and
only if there is not a match, writing, by the write circuit (120), the new data stored in the volatile memory (110) as current data into the first non-volatile memory (131) and the second non-volatile memory (132).

15. The method according to any one of the preceding claims, further comprising:

selecting a magnet tunnel junction cell for each of the first non-volatile memory (131) and the second non-volatile memory (132), wherein the magnet tunnel junction includes two ferromagnetic layers;
changing, by the write circuit (120) when writing, the magnetization of one of the two ferromagnetic layers; and
comparing, by the read circuit (140) when reading, a current through the first non-volatile memory (131) with a current through the second non-volatile memory (132).

**Patentansprüche**

1. Speicherschaltung (30), umfassend:

   einen flüchtigen Speicher (110);
   eine Schreibschaltung (120);
   einen ersten nichtflüchtigen Speicher (131) und einen zweiten nichtflüchtigen Speicher (132);
   eine Leseschaltung (140); und
   mindestens eine Auswahlschaltung;
   wobei:

   - die Speicherschaltung (30) so ausgestaltet ist, dass sie wahlweise eines von einem Taktsignal ersten Pegels und einem Taktsignal zweiten Pegels empfängt;
   - die Speicherschaltung (30) so ausgestaltet ist, dass, während jedes Taktsignals ersten Pegels:

     - die Schreibschaltung (120) so ausgestaltet ist, dass sie neue Daten, die in dem flüchtigen Speicher (110) gespeichert sind, als aktuelle Daten in den ersten nichtflüchtigen Speicher (131) und den zweiten nichtflüchtigen Speicher (132) schreibt; und
     - der flüchtige Speicher (110) so ausgestaltet ist, dass er die neuen Daten als die aktuellen Daten an die mindestens eine Auswahlschaltung überträgt;

   - die Speicherschaltung (30) so ausgestaltet ist, dass, während jedes Taktsignals zweiten Pegels:

     - die Leseschaltung (140) so ausgestaltet ist, dass sie die aktuellen Daten, die in dem ersten nichtflüchtigen Speicher (131) und in dem zweiten nichtflüchtigen Speicher (132) gespeichert sind, liest und die aktuellen Daten an die mindestens eine Auswahlschaltung überträgt; und
     - der flüchtige Speicher (110) so ausgestaltet ist, dass er neue Daten speichert; und

   - die mindestens eine Auswahlschaltung so ausgestaltet ist, dass sie die aktuellen Daten, die entweder von dem flüchtigen Speicher (110) oder von der Leseschaltung (140) übertragen wurden, abhängig davon ausgibt, ob die Speicherschaltung (30) das Taktsignal ersten Pegels oder das Taktsignal zweiten Pegels empfängt.

2. Speicherschaltung (30) nach Anspruch 1, die eine erste Auswahlschaltung (171) und eine zweite Auswahl schaltung (172) umfasst.

3. Speicherschaltung (30) nach Anspruch 2, wobei:

   - der flüchtige Speicher (110) so ausgestaltet ist, dass er:

     - Informationen empfängt, die aus einem Bit bestehen, das eines von einem Bitwert (D) und einem komplementären Bitwert ($\overline{D}$) aufweist;
     - die Informationen als neue Daten speichert, indem er sowohl den Bitwert (D) als auch den komplementären Bitwert ($\overline{D}$) speichert; und
     - die neuen Daten als die aktuellen Daten an die erste Auswahlschaltung (171) und die zweite Auswahlschaltung (172) überträgt, indem er den Bitwert (D) an die erste Auswahlschaltung (171) und den komplementären Bitwert ($\overline{D}$) an die zweite Auswahlschaltung (172) überträgt;

   - die Schreibschaltung (120) so ausgestaltet ist, dass sie die neuen Daten, die in dem flüchtigen Speicher (110) gespeichert sind, als die aktuellen Daten in den ersten nichtflüchtigen Speicher (131) und den zweiten nichtflüchtigen Speicher (132) schreibt, indem sie den Bitwert (D) in den ersten nichtflüchtigen Speicher (131) und

den komplementären Bitwert ($\overline{D}$) in den zweiten nichtflüchtigen Speicher (132) schreibt; und
- die Schreibschaltung (140) so ausgestaltet ist, dass sie die aktuellen Daten, die in dem ersten nichtflüchtigen Speicher (131) und dem zweiten nichtflüchtigen Speicher (132) gespeichert sind, an die erste Auswahlschaltung (171) und die zweite Auswahlschaltung (172) überträgt, indem sie den Bitwert (D) an die erste Auswahlschaltung (171) und den komplementären Bitwert ($\overline{D}$) an die zweite Auswahlschaltung (172) überträgt.

4. Speicherschaltung (30) nach Anspruch 3, wobei die Schreibschaltung (140) so ausgestaltet ist, dass sie gleichzeitig den Bitwert (D) in den ersten nichtflüchtigen Speicher (131) und den komplementären Bitwert ($\overline{D}$) in den zweiten nichtflüchtigen Speicher (132) schreibt.

5. Speicherschaltung (30) nach einem beliebigen der vorhergehenden Ansprüche, die ferner eine Vergleichsschaltung umfasst, wobei, während des Taktsignals ersten Pegels:

   - die Vergleichsschaltung so ausgestaltet ist, dass sie bestimmt, ob es eine Übereinstimmung zwischen den aktuellen Daten, die in dem ersten und dem zweiten nichtflüchtigen Speicher (131, 132) gespeichert sind, und den neuen Daten, die in dem flüchtigen Speicher (110) gespeichert sind, gibt; und
   - die Schreibschaltung (120) so ausgestaltet ist, dass sie die neuen Daten, die in dem flüchtigen Speicher (110) gespeichert sind, nur dann als aktuelle Daten in den ersten nichtflüchtigen Speicher (131) und den zweiten nichtflüchtigen Speicher (132) schreibt, wenn es keine Übereinstimmung gibt.

6. Speicherschaltung (30) nach einem beliebigen der vorhergehenden Ansprüche, wobei die Dauer des Taktsignals ersten Pegels länger als die Dauer des Taktsignals zweiten Pegels ist.

7. Speicherschaltung (30) nach einem beliebigen der Ansprüche 1 bis 5, wobei die Dauer des Taktsignals ersten Pegels kürzer als die Dauer des Taktsignals zweiten Pegels ist.

8. Speicherschaltung (30) nach einem beliebigen der vorhergehenden Ansprüche, wobei:

   - der erste nichtflüchtige Speicher (131) und der zweite nichtflüchtige Speicher (132) jeweils einen magnetischen Tunnelkontakt umfassen, der zwei ferromagnetische Schichten umfasst;
   - die Schreibschaltung (120) so ausgestaltet ist, dass sie die neuen Daten, die in dem flüchtigen Speicher (110) gespeichert sind, als die aktuellen Daten in den ersten nichtflüchtigen Speicher (131) und den zweiten nichtflüchtigen Speicher (132) schreibt, indem sie die Magnetisierung von einer der zwei ferromagnetischen Schichten ändert; und
   - die Leseschaltung (120) so ausgestaltet ist, dass sie die aktuellen Daten, die in dem ersten nichtflüchtigen Speicher (131) und in dem zweiten nichtflüchtigen Speicher (132) gespeichert sind, liest, indem sie einen Strompegel durch den ersten nichtflüchtigen Speicher (131) hindurch mit einem Strompegel durch den zweiten nichtflüchtigen Speicher (132) hindurch vergleicht.

9. Speicherschaltung (30) nach einem beliebigen der vorhergehenden Ansprüche, die ferner ein Verzögerungselement umfasst, das so ausgestaltet ist, dass, beim Einschalten der Speicherschaltung (30), die Leseschaltung (140) zuerst eingeschaltet wird.

10. Mikroprozessor, der eine oder mehrere Speicherschaltungen (30) nach einem beliebigen der vorhergehenden Ansprüche 1 bis 9 umfasst.

11. Verfahren zur Speicherung von Informationen in einer Speicherschaltung (30), wobei das Verfahren Folgendes umfasst:

   Empfangen, mittels der Speicherschaltung (30), wahlweise eines von einem Taktsignal ersten Pegels und einem Taktsignal zweiten Pegels;
   während jedes Taktsignals ersten Pegels:

   - Schreiben, mittels einer Schreibschaltung (120) der Speicherschaltung (30), neuer Daten, die in einem flüchtigen Speicher (110) der Speicherschaltung (30) gespeichert sind, als aktuelle Daten in einen ersten nichtflüchtigen Speicher (131) und einen zweiten nichtflüchtigen Speicher (132) der Speicherschaltung (30); und
   - Übertragen, mittels des flüchtigen Speichers (110), der neuen Daten als die aktuellen Daten an mindestens eine Auswahlschaltung der Speicherschaltung;

während jedes Taktsignals zweiten Pegels:

- Lesen, mittels einer Leseschaltung (140) der Speicherschaltung (30), der aktuellen Daten, die in dem ersten nichtflüchtigen Speicher (131) und in dem zweiten nichtflüchtigen Speicher (132) gespeichert sind, und Senden der aktuellen Daten an die mindestens eine Auswahlschaltung; und
- Speichern, mittels des flüchtigen Speichers (110), neuer Daten; und

Ausgeben, mittels der mindestens einen Auswahlschaltung, der aktuellen Daten, die entweder von dem flüchtigen Speicher (110) oder von der Leseschaltung (140) übertragen wurden, abhängig davon, ob die Speicherschaltung (30) das Taktsignal ersten Pegels oder das Taktsignal zweiten Pegels empfängt.

12. Verfahren nach Anspruch 11, wobei die Speicherschaltung (30) eine erste Auswahlschaltung (171) und eine zweite Auswahlschaltung (172) umfasst, wobei das Verfahren ferner Folgendes umfasst:

Empfangen, mittels des flüchtigen Speichers (110), von Informationen, die aus einem Bit bestehen, das eines von einem Bitwert $(D)$ und einem komplementären Bitwert $(\overline{D})$ aufweist;
Speichern, mittels des flüchtigen Speichers (110), der Informationen als neue Daten, indem sowohl der Bitwert $(D)$ als auch der komplementäre Bitwert $(\overline{D})$ gespeichert werden;
Übertragen, mittels des flüchtigen Speichers (110), der neuen Daten als die aktuellen Daten an die erste Auswahlschaltung (171) und die zweite Auswahlschaltung (172), indem der Bitwert $(D)$ an die erste Auswahlschaltung (171) und der komplementäre Bitwert $(\overline{D})$ an die zweite Auswahlschaltung (172) übertragen werden;
Schreiben, mittels der Schreibschaltung (120), der neuen Daten, die in dem flüchtigen Speicher (110) gespeichert sind, als die aktuellen Daten in den ersten nichtflüchtigen Speicher (131) und den zweiten nichtflüchtigen Speicher (132), indem der Bitwert $(D)$ in den ersten nichtflüchtigen Speicher (131) und der komplementäre Bitwert $(\overline{D})$ in den zweiten nichtflüchtigen Speicher (132) geschrieben werden; und
Übertragen, mittels der Leseschaltung (140), der aktuellen Daten, die in dem ersten nichtflüchtigen Speicher (131) und dem zweiten nichtflüchtigen Speicher (132) gespeichert sind, an die erste Auswahlschaltung (171) und die zweite Auswahlschaltung (172), indem der Bitwert $(D)$ an die erste Auswahlschaltung (171) und der komplementäre Bitwert $(\overline{D})$ an die zweite Auswahlschaltung (172) übertragen werden.

13. Verfahren nach Anspruch 12, wobei:
das Schreiben, mittels der Schreibschaltung (120), der neuen Daten, die in dem flüchtigen Speicher (110) als die aktuellen Daten gespeichert sind, ein gleichzeitiges Schreiben des Bitwerts $(D)$ in den ersten nichtflüchtigen Speicher (131) und des komplementären Bitwerts $(\overline{D})$ in den zweiten nichtflüchtigen Speicher (132) umfasst.

14. Verfahren nach einem beliebigen der vorhergehenden Ansprüche, das, während des Taktsignals ersten Pegels, ferner Folgendes umfasst:

Bestimmen, mittels einer Vergleichsschaltung, ob es eine Übereinstimmung zwischen den aktuellen Daten, die in dem ersten und dem zweiten nichtflüchtigen Speicher (131, 132) gespeichert sind, und den neuen Daten, die in dem flüchtigen Speicher (110) gespeichert sind, gibt; und
nur dann, wenn es keine Übereinstimmung gibt, Schreiben, mittels der Schreibschaltung (120) der neuen Daten, die in dem flüchtigen Speicher (110) gespeichert sind, als aktuelle Daten in den ersten nichtflüchtigen Speicher (131) und den zweiten nichtflüchtigen Speicher (132).

15. Verfahren nach einem beliebigen der vorhergehenden Ansprüche, ferner umfassend:

Auswählen einer Zelle mit magnetischem Tunnelkontakt für jeden von dem ersten nichtflüchtigen Speicher (131) und dem zweiten nichtflüchtigen Speicher (132), wobei der magnetische Tunnelkontakt zwei ferromagnetische Schichten umfasst;
Ändern, durch die Schreibschaltung (120) beim Schreiben, der Magnetisierung von einer der zwei ferromagnetischen Schichten; und
Vergleichen, durch die Leseschaltung (140) beim Lesen, eines Stroms durch den ersten nichtflüchtigen Speicher (131) hindurch mit einem Strom durch den zweiten nichtflüchtigen Speicher (132) hindurch.

**Revendications**

1. Circuit de mémoire (30) comportant :

   une mémoire volatile (110) ;
   un circuit d'écriture (120) ;
   une première mémoire non volatile (131) et une seconde mémoire non volatile (132) ;
   un circuit de lecture (140) ; et
   au moins un circuit sélecteur ;
   dans lequel :

   - le circuit de mémoire (30) est configuré pour recevoir en alternance un signal parmi un signal d'horloge de premier niveau et un signal d'horloge de second niveau ;
   - le circuit de mémoire (30) est configuré de sorte que, lors de chaque signal d'horloge de premier niveau :

      - le circuit d'écriture (120) soit configuré pour écrire de nouvelles données stockées dans la mémoire volatile (110) en tant que données actuelles dans la première mémoire non volatile (131) et la seconde mémoire non volatile (132) ; et
      - la mémoire volatile (110) soit configurée pour transmettre les nouvelles données en tant que données actuelles à le au moins un circuit sélecteur ;

   - le circuit de mémoire (30) est configuré de sorte que, lors de chaque signal d'horloge de second niveau :

      - le circuit de lecture (140) soit configuré pour lire les données actuelles stockées dans la première mémoire non volatile (131) et dans la seconde mémoire non volatile (132) et transmettre les données actuelles à le au moins un circuit sélecteur ; et
      - la mémoire volatile (110) soit configurée pour stocker de nouvelles données ; et

   - le au moins un circuit sélecteur est configuré pour délivrer les données actuelles transmises soit par la mémoire volatile (110) soit par le circuit de lecture (140), selon si le circuit de mémoire (30) reçoit le signal d'horloge de premier niveau ou le signal d'horloge de second niveau.

2. Circuit de mémoire (30) selon la revendication 1, comportant un premier circuit sélecteur (171) et un second circuit sélecteur (172).

3. Circuit de mémoire (30) selon la revendication 2, dans lequel :

   - la mémoire volatile (110) est configurée pour :

      - recevoir des informations constituées d'un bit ayant une valeur parmi une valeur de bit (D) et une valeur de bit complémentaire ($\overline{D}$) ;
      - stocker les informations en tant que nouvelles données par stockage à la fois de la valeur de bit (D) et de la valeur de bit complémentaire ($\overline{D}$) ; et
      - transmettre les nouvelles données en tant que données actuelles au premier circuit sélecteur (171) et au second circuit sélecteur (172) par transmission de la valeur de bit (D) au premier circuit sélecteur (171) et de la valeur de bit complémentaire ($\overline{D}$) au second circuit sélecteur (172) ;

   - le circuit d'écriture (120) est configuré pour écrire les nouvelles données stockées dans la mémoire volatile (110) en tant que données actuelles dans la première mémoire non volatile (131) et la seconde mémoire non volatile (132) par écriture de la valeur de bit (D) dans la première mémoire non volatile (131) et de la valeur de bit complémentaire ($\overline{D}$) dans la seconde mémoire non volatile (132) ; et
   - le circuit de lecture (140) est configuré pour transmettre les données actuelles stockées dans la première mémoire non volatile (131) et la seconde mémoire non volatile (132) au premier circuit sélecteur (171) et au second circuit sélecteur (172) par transmission de la valeur de bit (D) au premier circuit sélecteur (171) et de la valeur de bit complémentaire ($\overline{D}$) au second circuit sélecteur (172).

4. Circuit de mémoire (30) selon la revendication 3, dans lequel le circuit d'écriture (140) est configuré pour écrire simultanément la valeur de bit (D) dans la première mémoire non volatile (131) et la valeur de bit complémentaire

($\overline{\text{D}}$) dans la seconde mémoire non volatile (132).

**5.** Circuit de mémoire (30) selon l'une quelconque des revendications précédentes, comportant en outre un circuit de comparaison, dans lequel, lors du signal d'horloge de premier niveau :

- le circuit de comparaison est configuré pour déterminer s'il y a une correspondance entre les données actuelles stockées dans les première et seconde mémoires non volatiles (131, 132) et les nouvelles données stockées dans la mémoire volatile (110) ; et
- le circuit d'écriture (120) est configuré pour écrire les nouvelles données stockées dans la mémoire volatile (110) en tant que données actuelles dans la première mémoire non volatile (131) et la seconde mémoire non volatile (132) uniquement s'il n'y a pas de correspondance.

**6.** Circuit de mémoire (30) selon l'une quelconque des revendications précédentes, dans lequel la durée du signal d'horloge de premier niveau est plus longue que la durée du signal d'horloge de second niveau.

**7.** Circuit de mémoire (30) selon l'une quelconque des revendications 1 à 5, dans lequel la durée du signal d'horloge de premier niveau est plus courte que la durée du signal d'horloge de second niveau.

**8.** Circuit de mémoire (30) selon l'une quelconque des revendications précédentes, dans lequel :

- la première mémoire non volatile (131) et la seconde mémoire non volatile (132) comportent chacune une jonction par tunnel magnétique incluant deux couches ferromagnétiques ;
- le circuit d'écriture (120) est configuré pour écrire les nouvelles données stockées dans la mémoire volatile (110) en tant que données actuelles dans la première mémoire non volatile (131) et la seconde mémoire non volatile (132) par changement de la magnétisation de l'une des deux couches ferromagnétiques ; et
- le circuit de lecture (120) est configuré pour lire les données actuelles stockées dans la première mémoire non volatile (131) et dans la seconde mémoire non volatile (132) par comparaison d'un niveau actuel à travers la première mémoire non volatile (131) à un niveau actuel à travers la seconde mémoire non volatile (132).

**9.** Circuit de mémoire (30) selon l'une quelconque des revendications précédentes, comportant en outre un élément de retard, configuré de sorte que, lors de la mise sous tension du circuit de mémoire (30), le circuit de lecture (140) soit mis sous tension en premier.

**10.** Microprocesseur comportant un ou plusieurs circuits de mémoire (30) selon l'une quelconque des revendications précédentes 1 à 9.

**11.** Procédé permettant de stocker des informations dans un circuit de mémoire (30), le procédé comportant :

la réception, par le circuit de mémoire (30) en alternance, d'un signal parmi un signal d'horloge de premier niveau et un signal d'horloge de second niveau ;
lors de chaque signal d'horloge de premier niveau :

- l'écriture, par un circuit d'écriture (120) du circuit de mémoire (30), de nouvelles données stockées dans une mémoire volatile (110) du circuit de mémoire (30) en tant que données actuelles dans une première mémoire non volatile (131) et une seconde mémoire non volatile (132) du circuit de mémoire (30) ; et
- la transmission, par la mémoire volatile (110), des nouvelles données en tant que données actuelles à au moins un circuit sélecteur du circuit de mémoire ;

lors de chaque signal d'horloge de second niveau :

- la lecture, par un circuit de lecture (140) du circuit de mémoire (30), des données actuelles stockées dans la première mémoire non volatile (131) et dans la seconde mémoire non volatile (132) et la transmission des données actuelles à le au moins un circuit sélecteur ; et
- le stockage, par la mémoire volatile (110), de nouvelles données ; et

la délivrance, par le au moins un circuit sélecteur, des données actuelles transmises soit par la mémoire volatile (110) soit par le circuit de lecture (140), selon si le circuit de mémoire (30) reçoit le signal d'horloge de premier niveau ou le signal d'horloge de second niveau.

**12.** Procédé selon la revendication 11, dans lequel le circuit de mémoire (30) comporte un premier circuit sélecteur (171) et un second circuit sélecteur (172), le procédé comportant en outre :

la réception, par la mémoire volatile (110), d'informations constituées d'un bit ayant une valeur parmi une valeur de bit (D) et une valeur de bit complémentaire ($\overline{D}$) ;
le stockage, par la mémoire volatile (110), des informations en tant que nouvelles données par stockage à la fois de la valeur de bit (D) et de la valeur de bit complémentaire ($\overline{D}$) ;
la transmission, par la mémoire volatile (110), des nouvelles données en tant que données actuelles au premier circuit sélecteur (171) et au second circuit sélecteur (172) par transmission de la valeur de bit (D) au premier circuit sélecteur (171) et de la valeur de bit complémentaire ($\overline{D}$) au second circuit sélecteur (172) ;
l'écriture, par le circuit d'écriture (120), des nouvelles données stockées dans la mémoire volatile (110) en tant que données actuelles dans la première mémoire non volatile (131) et la seconde mémoire non volatile (132) par écriture de la valeur de bit(D) dans la première mémoire non volatile (131) et de la valeur de bit complémentaire ($\overline{D}$) dans la seconde mémoire non volatile (132) ; et
la transmission, par le circuit de lecture (140), des données actuelles stockées dans la première mémoire non volatile (131) et la seconde mémoire non volatile (132) au premier circuit sélecteur (171) et au second circuit sélecteur (172) par transmission de la valeur de bit (D) au premier circuit sélecteur (171) et de la valeur de bit complémentaire ($\overline{D}$) au second circuit sélecteur (172).

**13.** Procédé selon la revendication 12, dans lequel :
l'écriture, par le circuit d'écriture (120), des nouvelles données stockées dans la mémoire volatile (110) en tant que données actuelles comporte simultanément l'écriture de la valeur de bit (D) dans la première mémoire non volatile (131) et de la valeur de bit complémentaire ($\overline{D}$) dans la seconde mémoire non volatile (132).

**14.** Procédé selon l'une quelconque des revendications précédentes, comportant en outre, lors du signal d'horloge de premier niveau :

la détermination, par un circuit de comparaison, pour savoir s'il y a une correspondance entre les données actuelles stockées dans les première et seconde mémoires non volatiles (131, 132) et les nouvelles données stockées dans la mémoire volatile (110) ; et
uniquement s'il n'y a pas de correspondance, l'écriture, par le circuit d'écriture (120), des nouvelles données stockées dans la mémoire volatile (110) en tant que données actuelles dans la première mémoire non volatile (131) et la seconde mémoire non volatile (132).

**15.** Procédé selon l'une quelconque des revendications précédentes, comportant en outre :

la sélection d'une cellule de jonction par tunnel magnétique pour chaque mémoire parmi la première mémoire non volatile (131) et la seconde mémoire non volatile (132), dans lequel la jonction par tunnel magnétique inclut deux couches ferromagnétiques ;
le changement, par le circuit d'écriture (120) lors de l'écriture, de la magnétisation de l'une des deux couches ferromagnétiques ; et
la comparaison, par le circuit de lecture (140) lors de la lecture, d'un courant à travers la première mémoire non volatile (131) à un courant à travers la seconde mémoire non volatile (132).

Figure 1a – Prior art

Master Latch                                      Slave Latch

Figure 1b – Prior art

20

**Conventional CMOS Flip-Flop**

D

Master Latch → Slave Latch

Q

CLK

21                22

NV Storage

23

$\overline{Q}$

Figure 2a – Prior art

EP 3 200 192 B1

Figure 2b – Prior art

Figure 3c

Figure 3a

Figure 3b

Figure 4a

Figure 4b

EP 3 200 192 B1

Vdd_Logic

MP3 MP1    MP0 MP2

$\overline{Qm}$

MN1    MN0

Qm

MTJ1    MTJ0

SEN

MN2

Gnd

Figure 4c

Vdd_Logic

MP3 MP1    MP0 MP2

$\overline{Qm}$

MN1    MN0

Qm

V1=Vdd_Logic-Vtn1    V0=Vdd_Logic-Vtn0

MTJ1    MTJ0

SEN='0'

MN2

Gnd

Figure 4d

Figure 4e

EP 3 200 192 B1

**30**

**NVNS-FF**

D

32

NV
component

CLK

Q

31

CMOS latch

Q̄

**Figure 5a**

➢ CMOS latch drives 'Q' & 'Q̄'
➢ Write to NV component

CLK

Initial phase | Normal phase

➢ NV component drives 'Q' & 'Q̄'
➢ Write to CMOS latch

**Figure 5b**

EP 3 200 192 B1

Figure 6a

Figure 6b

EP 3 200 192 B1

Figure 6c

EP 3 200 192 B1

Figure 7a

Figure 7b

Figure 7c

Figure 8

EP 3 200 192 B1

Figure 9

Figure 10

EP 3 200 192 B1

CLK

Internal CLK

D

Magn. Of MTJ 1

Magn. Of MTJ 2

Read_out

Read_out

Q

$\overline{Q}$

Figure 11

read_out

DN2

CLK_new

read_out

CLK

Figure 12

Figure 13

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 2015213869 A1

### Non-patent literature cited in the description

- **NEIL H. E. WESTE ; DAVID HARRIS.** CMOS VLSI Design: A circuit and system perspective. 405
- **KON-WOO KWON ; SRI HARSHA CHODAY ; YU-SUNG KIM ; XUANYAO FONG ; SANG PHILL PARK ; KAUSHIK ROY.** SHE-NVFF: Spin Hall Effect-Based Nonvolatile Flip-Flop for Power Gating Architecture. *IEEE ELECTRO DEVICE LETTERS,* April 2014, vol. 35 (4
- **ERYA DENG ; YUE ZHANG ; WANG KANG ; BERNARD DIENY ; JACQUES-OLIVIER KLEIN ; GUILLAUME PRENAT ; WEISHENG ZHAO.** Synchronous 8-bit Non-Volatile Full-Adder based on Spin Transfer Torque Magnetic Tunnel Junction. *IEEE TRANSACTIONS ON CIRCUITS AND SYSTEMS-I: REGULAR PAPERS,* July 2015, vol. 62 (7
- **RAJENDRA BISHNOI ; MOJTABA EBRAHIMI ; FABIAN OBORIL ; MEHDI B. TAHOORI.** *Asynchronous Asymmetrical Write Termination (AAWT) for a Low Power STT-MRAM,* 2014
- **SEYEDHAMIDREZA MOTAMAN ; SWAROOP GHOSH ; NITIN RATHI.** *Impact of Process-Variations in STTRAM and Adaptive Boosting for Robustness,* 2015
- **WEISHENG ZHAO ; CLAUDE CHAPPERT ; VIRGILE JAVERLIAC ; JEAN-PIERRE NOZIÈRE.** High Speed, High Stability and Low Power Sensing Amplifier for MTJ/CMOS Hybrid Logic Circuits. *IEEE TRANSACTIONS ON MAGNETICS,* October 2009, vol. 45 (10
- **K. JABEUR ; G. PRENAT ; G. DI PENDINA ; L. BUDA-PREJBEANU ; I. L. PREJBEANU ; B. DIENY.** Compact model of a three-terminal MRAM device based on spin orbit torque switching. *ISCDG,* 2013, 1-4
- **N. CHOUDHARY ; S. WADHAVKAR ; T. SHAH ; H. MAYUKH ; J. GANDHI ; B. DWIEL ; S. NAVADA ; H. NAJAF-ABADI ; E. ROTENBERG.** FabScalar: Automating Superscalar Core Design. *Micro,* 2012, 48-59